# EUROPEAN PATENT SPECIFICATION

(11) **EP 4 401 142 B1**
(45) Date of publication and mention of the grant of the patent: **27.05.2026**
(21) Application number: 24150194.9
(22) Date of filing: 03.01.2024
(51) Int. Cl.: H10F 39/00

(54) **IMAGE SENSOR HAVING NANO-PHOTONIC LENS ARRAY AND ELECTRONIC APPARATUS INCLUDING THE SAME**
BILDSENSOR MIT NANOPHOTONISCHER LINSENANORDNUNG UND ELEKTRONISCHE VORRICHTUNG DAMIT
CAPTEUR D'IMAGE AYANT UN RÉSEAU DE LENTILLES NANOPHOTONIQUES ET APPAREIL ÉLECTRONIQUE LE COMPRENANT

(30) Priority: 12.01.2023 KR 20230004926
(43) Date of publication of application: 17.07.2024
(73) Proprietor: Samsung Electronics Co., Ltd., Suwon-si, Gyeonggi-do 16677 (KR)
(72) Inventor: LEE, Sangyun, 16678, Suwon-si, (KR); ROH, Sookyoung, 16678, Suwon-si, (KR); YUN, Seokho, 16678, Suwon-si, (KR); LEE, Junho, 16678, Suwon-si, (KR)
(74) Representative: Elkington and Fife LLP

(56) References cited:
- US-A1- 2021 126 030
- US-A1- 2022 326 415

## Description

### FIELD OF THE INVENTION

One or more example embodiments relate to an image sensor including a nano-photonic lens array and an electronic apparatus including the image sensor.

### BACKGROUND OF THE INVENTION

Image sensors generally sense the color of incident light by using a color filter. However, a color filter may have low light utilization efficiency because the color filter absorbs light of colors other than the intended color of light. For example, in the case in which a red-green-blue (RGB) color filter is used, only 1/3 of the incident light is transmitted therethrough and the other part of the incident light, that is, 2/3 of the incident light, is absorbed. Thus, the light utilization efficiency is only about 33%. Thus, in a color display apparatus or a color image sensor, most light loss occurs in the color filter.

US 2022/326415 A1 describes an image sensor including a planar nanophotonic microlens array including a plurality of planar nanophotonic microlenses.

### SUMMARY OF THE INVENTION

One or more example embodiments provide an image sensor including a nano-photonic lens array and having an improved optical efficiency, and an electronic apparatus including the image sensor.

One or more example embodiments also provide an image sensor capable of reconstructing spatial resolution information while using a nano-photonic lens array and an electronic apparatus including the same.

Additional aspects will be set forth in part in the description which follows and, in part, will be apparent from the description, or may be learned by practice of presented embodiments of the disclosure.

According to an aspect of an example embodiment, there is provided an image sensor according to claim 1

Each of the plurality of nano-structures may have a pillar shape and may be smaller than a range of wavelengths of visible light.

Each of the plurality of nano-structures may have a width less than wavelengths of visible light and may have a bar shape extending in a diagonal direction of the plurality of pixels.

The plurality of nano-structures may have a binary pattern that is digitized in a two-dimensional matrix, and each of a plurality of cells forming the two-dimensional matrix may be filled with one of a first dielectric material having a first refractive index and a second dielectric material having a second refractive index that is lower than the first refractive index.

The plurality of pixels may include a first pixel, a second pixel, a third pixel, and a fourth pixel, the plurality of color filters may include a first color filter corresponding to the first pixel, a second color filter corresponding to the second pixel, a third color filter corresponding to the third pixel, and a fourth color filter corresponding to the fourth pixel, the nano-photonic lens array may include a first lens corresponding to the first pixel, a second lens corresponding to the second pixel, a third lens corresponding to the third pixel, and a fourth lens corresponding to the fourth pixel, the first color filter and the fourth color filter are configured to transmit the light of the first wavelength band, the second color filter is configured to transmit the light of the second wavelength band, and the third color filter is configured to transmit the light of the third wavelength band, and the plurality of nano-structures are disposed in the first lens, the second lens, the third lens, and the fourth lens to separate and condense the incident light.

The plurality of nano-structures may be further configured to: condense the light of the first wavelength band onto the first pixel, the second pixel, the third pixel, and the fourth pixel, condense the light of the second wavelength band onto the second pixel, and condense the light of the third wavelength band onto the third pixel.

A phase profile of the light of the first wavelength band immediately after passing through the nano-photonic lens array may have a phase repeated at a period that is the same as a lens arrangement period in the nano-photonic lens array, and a phase profile of the light of the second wavelength band and a phase profile of the light of the third wavelength band immediately after passing through the nano-photonic lens array have phases repeated at a period that is twice the lens arrangement period in the nano-photonic lens array.

A phase profile of the light of the first wavelength band immediately after passing through the nano-photonic lens array may decrease gradually in a form of a concentric circle from a center of each of the first lens, the second lens, the third lens, and the fourth lens.

A phase of the light of the first wavelength band may have a minimum phase at a boundary between the first lens and the second lens, a boundary between the first lens and the third lens, a boundary between the fourth lens and the second lens, and a boundary between the fourth lens and the third lens, and may have a minimum phase at apexes in each of the first lens, the second lens, the third lens, and the fourth lens.

Based on a highest phase of the light of the first wavelength band being set as 2π, the minimum phase at the boundary between the first lens and the second lens, the boundary between the first lens and the third lens, the boundary between the fourth lens and the second lens, and the boundary between the fourth lens and the third lens may be 1.5π to 1.7π, and the minimum phase at apexes of each of the first lens, the second lens, the third lens, and the fourth lens is π to 1.3π.

A phase profile of the light of the second wavelength band immediately after passing through the nano-photonic lens array may gradually decrease from a center of the second lens in a form of a concentric circle.

A phase of the light of the second wavelength band may have a minimum phase at a center of each of the first lens, the third lens, and the fourth lens.

Based on a highest phase of the light of the second wavelength band being set as 2π, the minimum phase at the center of each of the first lens and the fourth lens is 1.4π to 1.6π, and the minimum phase at the center of the third lens may be 0.9π to 1.3π.

A phase profile of the light of the third wavelength band immediately after passing through the nano-photonic lens array may gradually decrease from a center of the third lens in a form of a concentric circle.

The phase profile of the light of the third wavelength band may have a minimum phase at a center of each of the first lens, the second lens, and the fourth lens.

Based on a highest phase of the light of the second wavelength band being set as 2π, the minimum phase at the center of the first lens and the center of the fourth lens is 1.4π to 1.6π, and the minimum phase at the center of the second lens may be 0.9π to 1.3π.

Each of the plurality of nano-structures may have a pillar shape and may be smaller than a range of wavelengths of visible light, the nano-structures may be respectively disposed at a center of each of the first lens, the second lens, the third lens, and the fourth lens included in the nano-photonic lens array, a diameter of a nano-structure disposed at the center of the first lens may be equal to a diameter of a nano-structure disposed at the center of the fourth lens, and the diameter of the nano-structure disposed at the center of the first lens, a diameter of a nano-structure disposed at the center of the second lens, and a diameter of a nano-structure disposed at the center of the third lens may be different from each other.

The image sensor may further include a planarization layer between the color filter layer and the nano-photonic lens array.

According to an aspect of the disclosure, there is provided an electronic apparatus according to claim 14.

### BRIEF DESCRIPTION OF THE DRAWINGS

The above and other aspects, features, and advantages of example embodiments will be more apparent from the following description taken in conjunction with the accompanying drawings, in which:
FIG. 1 is a block diagram of an image sensor according to an example embodiment;
FIGS. 2A, 2B, and 2C are diagrams showing examples of various pixel arrangements in a pixel array of an image sensor according to example embodiments;
FIGS. 3A and 3B are cross-sectional views showing a structure of a pixel array in an image sensor according to an example embodiment;
FIG. 4 is a plan view showing a structure of a sensor substrate in the pixel array of FIGS. 3A and 3B;
FIG. 5 is a plan view schematically showing a structure of a color filter layer of FIGS. 3A and 3B;
FIGS. 6A, 6B, 6C, and 6D are plan views showing various example structures of a nano-photonic lens array shown in FIGS. 3A and 3B;
FIGS. 7A, 7B, and 7C are diagrams showing examples of phase profiles of blue light, green light, and red light after passing through a nano-photonic lens array, on a plane of the nano-photonic lens array;
FIG. 8 is a diagram showing an example of passage of blue light and red light that are separated according to color by a nano-photonic lens array;
FIG. 9 is a diagram showing phase profiles of green light and blue light that have passed through a nano-photonic lens array, on a cross-section of FIG. 3A;
FIG. 10 is a diagram showing a direction of passage of green light incident on a nano-photonic lens array;
FIG. 11 is a diagram showing an example of passage of blue light incident on a periphery of a second lens in a nano-photonic lens array;
FIG. 12 is a diagram showing an example of an array of a blue light condensing region formed by a nano-photonic lens array;
FIG. 13 is a diagram showing phase profiles of red light and green light that have passed through a nano-photonic lens array on a cross-section of FIG. 3B;
FIG. 14 is a diagram showing an example of passage of red light incident on a periphery of a third lens in a nano-photonic lens array;
FIG. 15 is a diagram showing an example of an array of a red light condensing region formed by a nano-photonic lens array;
FIG. 16 is a diagram showing an example of light utilization efficiency of an image sensor according to a related example;
FIG. 17 is a diagram showing an example of light utilization efficiency of an image sensor according to an example embodiment;
FIG. 18 is a diagram showing an example of a modulation transfer function (MTF) curve of a full-color image obtained by applying an example image signal processing algorithm;
FIG. 19 is a diagram showing an example of an MTF curve of a full-color image obtained by applying another example image signal processing algorithm;
FIG. 20 is a block diagram of an electronic device including an image sensor according to an example embodiment; and
FIG. 21 is a block diagram showing a camera module of FIG. 20.

### DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, an image sensor including a nano-photonic lens array and an electronic apparatus including the image sensor will be described in detail with reference to accompanying drawings. The embodiments of the disclosure are capable of various modifications and may be embodied in many different forms. In the drawings, like reference numerals denote like components, and sizes of components in the drawings may be exaggerated for convenience of explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

**In** addition, the terms such as "... unit", "module", etc. provided herein indicates a unit performing a function or operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe technical detail, and the scope of rights is not limited by these terms unless the context is limited by the claims.

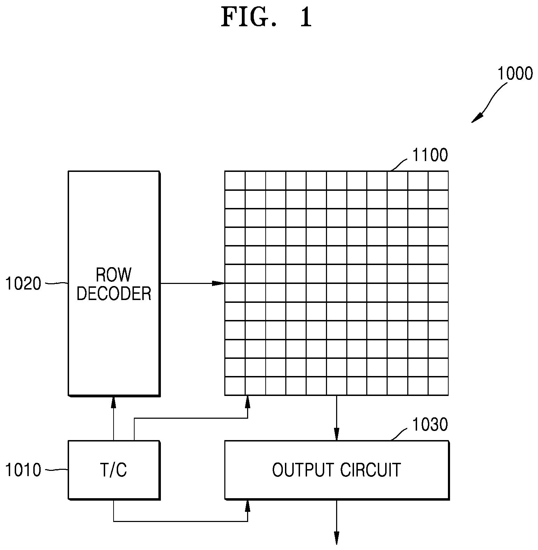

FIG. 1 is a schematic block diagram of an image sensor 1000 according to an example embodiment. Referring to FIG. 1, the image sensor 1000 may include a pixel array 1100, a timing controller 1010, a row decoder 1020, and an output circuit 1030. The image sensor 1000 may include a charge-coupled device (CCD) image sensor or a complementary metal oxide semiconductor (CMOS) image sensor.

The pixel array 1100 includes pixels that are two-dimensionally disposed in a plurality of rows and columns. The row decoder 1020 selects one of the rows in the pixel array 1100 in response to a row address signal output from the timing controller 1010. The output circuit 1030 outputs a photosensitive signal, in a column unit, from a plurality of pixels disposed in the selected row. To this end, the output circuit 1030 may include a column decoder and an analog-to-digital converter (ADC). For example, the output circuit 1030 may include a plurality of ADCs that are disposed respectively to columns between the column decoder and the pixel array 1100, or one ADC disposed at an output end of the column decoder. The timing controller 1010, the row decoder 1020, and the output circuit 1030 may be implemented as one chip or in separate chips. A processor for processing an image signal output from the output circuit 1030 may be implemented as one chip with the timing controller 1010, the row decoder 1020, and the output circuit 1030.

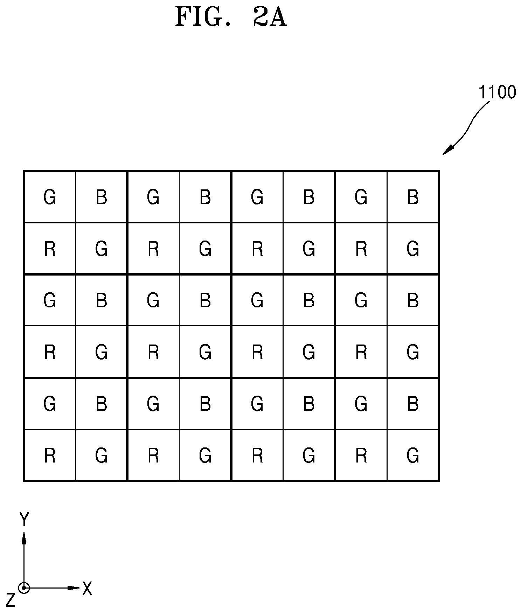

The pixel array 1100 may include a plurality of pixels that sense light of different wavelengths. The pixel arrangement may be implemented in various ways. For example, FIGS. 2A to 2C show various pixel arrangements in the pixel array 1100 of the image sensor 1000.

FIG. 2A shows a Bayer pattern that is generally adopted in the image sensor 1000. Referring to FIG. 2A, one unit pattern includes four quadrant regions, and first through fourth quadrants may be the blue pixel B, the green pixel G, the red pixel R, and the green pixel G, respectively. The unit patterns may be repeatedly and two-dimensionally disposed in a first direction (X direction) and a second direction (Y direction). For example, two green pixels G are disposed in one diagonal direction and one blue pixel B and one red pixel R are disposed in another diagonal direction in a unit pattern of a 2×2 array. In the entire arrangement of pixels, a first row in which a plurality of green pixels G and a plurality of blue pixels B are alternately disposed in the first direction and a second row in which a plurality of red pixels R and a plurality of green pixels G are alternately disposed in the first direction are repeatedly disposed in a second direction.

As described above, in the Bayer pattern, the number of green pixels is twice more than those of the blue pixels and the red pixels. For example, an image signal of a green channel has a spatial sampling rate twice as high as an image signal of a blue channel and a red channel, and has more spatial resolution information about captured scene. Therefore, when a full-color image is generated through a demosaic algorithm, most of the spatial resolution information may be reconstructed by using an image signal of the green channel having relatively high spatial sampling rate. Demosaic process may be performed on the blue channel and the red channel by using the reconstructed information.

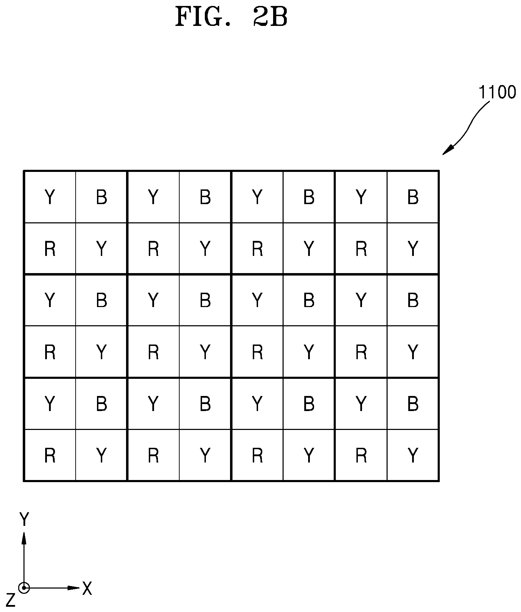

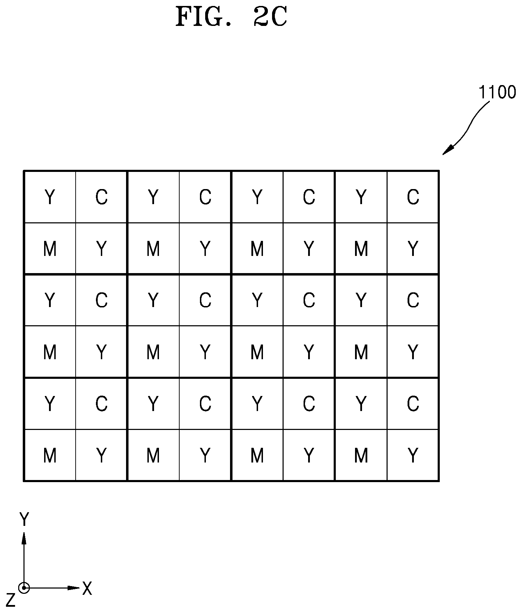

The pixel array 1100 may be disposed in various arrangement patterns, rather than the Bayer pattern. For example, referring to FIG. 2B, a red-yellow-blue (RYB) arrangement in which a yellow pixel Y is used instead of a green pixel G in the Bayer pattern may be used. Also, referring to FIG. 2C, a cyan-magenta-yellow (CMY) arrangement in which a cyan pixel C, a magenta pixel M, and two yellow pixels Y form one unit pattern may be used. When the pixel arrangement method shown in FIGS. 2B and 2C is used, most of the spatial resolution information may be reconstructed by using the image signal of the yellow channel, instead of the green channel. According to another example embodiment, an RGBW arrangement, in which a green pixel G, a red pixel R, a blue pixel, and a white pixel W form one unit pattern, may be used. In addition to the above examples, the pixels in the pixel array 1100 may be disposed in various ways according to color characteristics of the image sensor 1000. Hereinafter, it will be described that the pixel array 1100 of the image sensor 1000 has a Bayer pattern, but the operating principles may be applied to other patterns of pixel arrangement than the Bayer pattern.

Hereinafter, for convenience of description, an example in which the pixel array 1100 has a Bayer pattern structure will be described as an example.

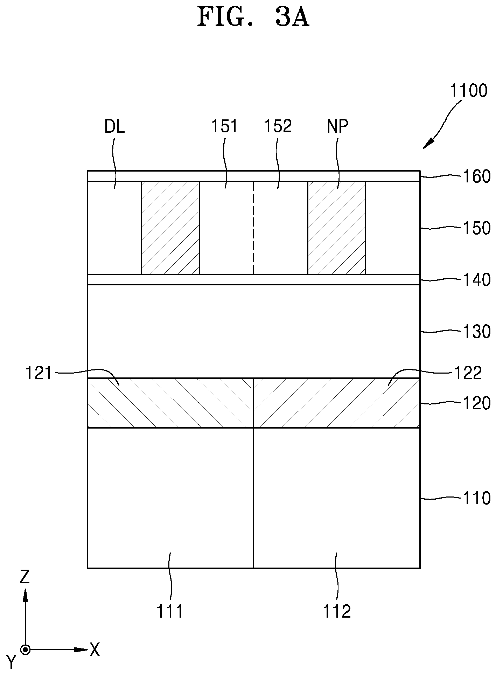

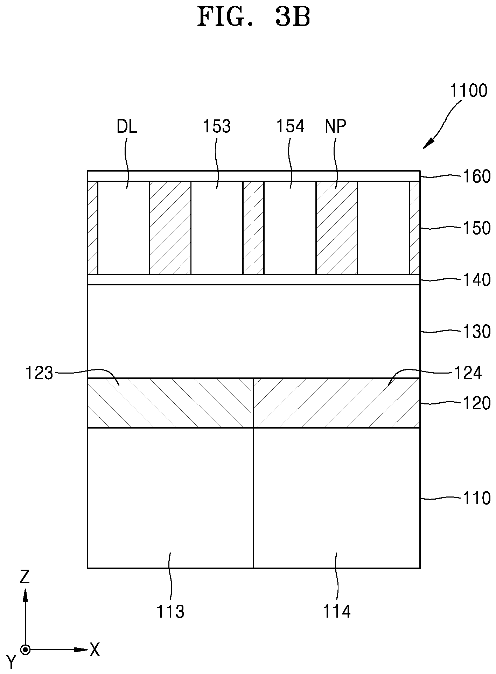

FIGS. 3A and 3B are cross-sectional views showing a structure of the pixel array 1100 in the image sensor 1000 according to an example embodiment. FIG. 3A shows a cross-section of the pixel array 1100 taken along the first direction (X-direction), and FIG. 3B shows a cross-section of the pixel array 1100, taken along the first direction (X-direction) at a location different from that of FIG. 3A in the second direction (Y-direction).

Referring to FIGS. 3A and 3B, the pixel array 1100 may include a sensor substrate 110, a color filter layer 120 disposed on the sensor substrate 110, a planarization layer 130 that is transparent and disposed on the color filter layer 120, and a nano-photonic lens array 150 disposed on the planarization layer 130. Also, the pixel array 1100 may further include an etch stop layer 140 between the nano-photonic lens array 150 and the planarization layer 130. Also, the pixel array 1100 may further include an anti-reflection layer 160 disposed on a light incident surface of the nano-photonic lens array 150. The etch stop layer 140 and the anti-reflection layer 160 may be omitted.

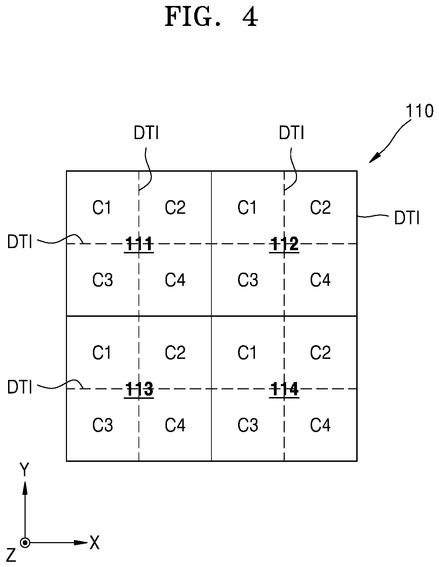

FIG. 4 is a plan view showing a structure of a sensor substrate 110 in the pixel array 1100 of FIGS. 3A and 3B. Referring to FIG. 4, the sensor substrate 110 may include a plurality of pixels sensing incident light. For example, the sensor substrate 110 may include a first pixel 111, a second pixel 112, a third pixel 113, and a fourth pixel 114 that convert incident light into electrical signals and generate an image signal. The first pixel 111, the second pixel 112, the third pixel 113, and the fourth pixel 114 may form one unit Bayer pattern. For example, the first and fourth pixels 111 and 114 may be green pixels sensing green light, the second pixel 112 may be a blue pixel sensing blue light, and the third pixel 113 may be a red pixel sensing red light.

FIGS. 3A, 3B, and 4 only show one unit Bayer pattern including four pixels as an example, but the pixel array 1100 may include a plurality of Bayer patterns that are two-dimensionally arranged. For example, a plurality of first pixels 111 and a plurality of second pixels 112 may be alternately disposed in a first direction, and a plurality of third pixels 113 and a plurality of fourth pixels 114 may be alternately disposed in the first direction on a cross-section located differently in a second direction perpendicular to the first direction. Also, the plurality of first pixels 111 and the plurality of fourth pixels 114 may be disposed in a first diagonal direction and the plurality of second pixels 112 and the plurality of third pixels 113 may be disposed in a second diagonal direction crossing the first diagonal direction.

In an example, each of the first to fourth pixels 111, 112, 113, and 114 may include one photosensitive cell. For example, each of the first to fourth pixels 111, 112, 113, and 114 may include one photodiode.

In another example, each of the first to fourth pixels 111, 112, 113, and 114 may include a plurality of photosensitive cells that independently sense incident light. In this case, each of the first to fourth pixels 111, 112, 113, and 114 may include a plurality of photodiodes. For example, each of the first to fourth pixels 111, 112, 113, and 114 may include a first photosensitive cell C1, a second photosensitive cell C2, a third photosensitive cell C3, and a fourth photosensitive cell C4. The first to fourth photosensitive cells C1, C2, C3, and C4 may be two-dimensionally disposed in the first direction and the second direction. For example, in each of the first to fourth pixels 111, 112, 113, and 114, the first to fourth photosensitive cells C1, C2, C3, and C4 may be disposed in a 2x2 array.

FIG. 4 shows an example in which each of the first to fourth pixels 111, 112, 113, and 114 includes four photosensitive cells, but four or more independent photosensitive cells may be grouped and two-dimensionally arranged. For example, each of the first to fourth pixels 111, 112, 113, and 114 may include a plurality of independent photosensitive cells that are grouped and disposed in a 3x3 array or 4x4 array. Hereinafter, an example in which each of the first to fourth pixels 111, 112, 113, and 114 includes the photosensitive cells disposed in a 2x2 array will be described for convenience of description.

When each of the first to fourth pixels 111, 112, 113, and 114 includes a plurality of photosensitive cells, an auto-focusing signal may be obtained from a difference between output signals from adjacent photosensitive cells. For example, an auto-focusing signal in the first direction may be generated from a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4. Also, an auto-focusing signal in the second direction may be generated from a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4.

A general image signal may be obtained by summing output signals from the first to fourth photosensitive cells C1, C2, C3, and C4. For example, a first green image signal may be generated by summing the output signals from the first to fourth photosensitive cells C1, C2, C3, and C4 of the first pixel 111, a blue image signal may be generated by summing the output signals from the first to fourth photosensitive cells C1, C2, C3, and C4 the second pixel 112, a red image signal may be generated by summing the output signals from the first to fourth photosensitive cells C1, C2, C3, and C4 of the third pixel 113, and a second green image signal may be generated by summing the output signals from the first to fourth photosensitive cells C1, C2, C3, and C4 of the fourth pixel 114.

Also, each of the first to fourth pixels 111, 112, 113, and 114 may include isolations **DTI** that electrically isolate the plurality of photosensitive cells from one another. The isolation **DTI** may have, for example, a deep trench isolation structure. The deep trench may be filled with air or an electrically insulating material. The isolations **DTI** may extend in the first direction and the second direction so as to divide each of the first to fourth pixels 111, 112, 113, and 114 into four. The first to fourth photosensitive cells C1, C2, C3, and C4 in each of the first to fourth pixels 111, 112, 113, and 114 may be isolated from one another by the isolations DTI. The isolation DTI extending in the first direction and the isolation DTI extending in the second direction may cross each other at the center of each of the first to fourth pixels 111, 112, 113, and 114.

Also, the isolations DTI may be disposed in the first direction and the second direction between adjacent pixels from among the first to fourth pixels 111, 112, 113, and 114. Therefore, the first to fourth pixels 111, 112, 113, and 114 may be isolated from one another due to the isolations DTI. The isolation DTI extending in the first direction and the isolation DTI extending in the second direction may cross each other at the center of the unit Bayer pattern including the first to fourth pixels 111, 112, 113, and 114.

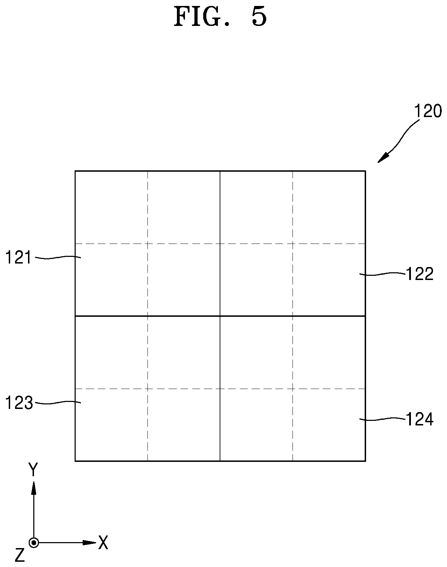

FIG. 5 is a plan view schematically showing a structure of the color filter layer 120 of FIGS. 3A and 3B. Referring to FIG. 5, the color filter layer 120 may include a plurality of color filters that are disposed between the sensor substrate 110 and the nano-photonic lens array 150 to transmit light of a certain wavelength band and absorb light of another wavelength band. For example, the color filter layer 120 may include a first color filter 121 that transmits light of a first wavelength band and absorbs light of another wavelength band, a second color filter 122 that transmits light of a second wavelength band that is different from the first wavelength band and absorbs light of another wavelength band, a third color filter 123 that transmits light of a third wavelength band that is different from the first and second wavelength bands and absorbs light of another wavelength band, and a fourth color filter 124 that transmits light of the first wavelength band and absorbs light of another wavelength band. Therefore, in the color filter layer 120, the total number of the first color filters 121 and the fourth color filters 124 transmitting the light of the first wavelength band is twice as many as the number of the second color filter 122 transmitting the light of the second wavelength band, and twice as many as the number of the third color filters 123 transmitting the light of the third wavelength band. FIG. 5 only shows an example of one unit Bayer pattern, but a plurality of first color filters 121 and a plurality of second color filters 122 may be alternately disposed in the first direction, and a plurality of third color filters 123 and a plurality of fourth color filters 124 may be alternately disposed in the first direction on a cross-section that is at a different location in the second direction that is perpendicular to the first direction.

The first color filter 121 may be disposed to face the first pixel 111 in a third direction, the second color filter 122 may be disposed to face the second pixel 112 in the third direction, the third color filter 123 may be disposed to face the third pixel 113 in a third direction (Z-direction), and the fourth color filter 124 may be disposed to face the fourth pixel 114 in the third direction. Accordingly, the first pixel 111 and the fourth pixel 114 may sense the light of the first wavelength band that has passed through the first color filter 121 and the fourth color filter 124 respectively corresponding thereto. Also, the second pixel 112 may sense the light of the second wavelength band that has passed through the second color filter 122 corresponding thereto. The third pixel 113 may sense the light of the third wavelength band that has passed through the third color filter 123 corresponding thereto. For example, the first color filter 121 and the fourth color filter 124 may be green color filters transmitting the green light, the second color filter 122 may be a blue color filter transmitting the blue light, and the third color filter 123 may be a red color filter transmitting the red light.

Dashed lines shown in FIG. 5 indicate the isolations between the photosensitive cells in the first to fourth pixels 111, 112, 113, and 114. As shown in FIG. 5, the first to fourth color filters 121, 122, 123, and 124 may be disposed to face all the photosensitive cells in the first to fourth pixels 111, 112, 113, and 114 respectively corresponding thereto in the third direction. For example, the first color filter 121 covers all photosensitive cells in the first pixel 111, the second color filter 122 covers all photosensitive cells in the second pixel 112, the third color filter 123 covers all photosensitive cells in the third pixel 113, and the fourth color filter 124 covers all photosensitive cells in the fourth pixel 114.

The first to fourth color filters 121, 122, 123, and 124 in the color filter layer 120 may be formed of, for example, an organic polymer material. For example, the first to fourth color filters 121, 122, 123, and 124 may include a coloring agent, binder resin, polymer photoresist, etc. The first and fourth color filters 121 and 124 may be organic color filters including green organic dye or a green organic pigment as a coloring agent, the second color filter 122 may be an organic color filter including a blue organic dye or a blue organic pigment as a coloring agent, and the third color filter 123 may be an organic color filter including a red organic dye or a red organic pigment as a coloring agent. The color filter layer 120 may further include a black matrix disposed at boundaries between the first to fourth color filters 121, 122, 123, and 124. The black matrix may include, for example, carbon black.

In FIGS. 3A and 3B, although the color filter layer 120 is shown to have a flat upper surface as an example, the upper surface of each of the first to fourth color filters 121, 122, 123, and 124 may not be flat. Also, thicknesses of the first to fourth color filters 121, 122, 123, and 124 and the black matrix may not be identical to each other. The planarization layer 130 disposed between the color filter layer 120 and the nano-photonic lens array 150 may provide a flat surface for forming the nano-photonic lens array 150 thereon. The planarization layer 130 may include an organic polymer material that is suitable for being stacked on the color filter layer 120 that is formed of an organic material and may more easily form a flat surface. The organic polymer material forming the planarization layer 130 may be transparent with respect to visible light. For example, the planarization layer 130 may include at least one organic polymer material from an epoxy resin, polyimide, polycarbonate, polyacrylate, and polymethyl methacrylate (PMMA). The planarization layer 130 may be formed on the color filter layer 120 by, for example, a spin coating method, and may have a flat upper surface through a thermal treatment.

The nano-photonic lens array 150 may be disposed on the planarization layer 130. FIGS. 3A and 3B show that the nano-photonic lens array 150 is directly disposed on the planarization layer 130, but a protective layer for preventing damage to the planarization layer 130 that is formed of an organic polymer material during the process of forming the nano-photonic lens array 150 may be disposed on the planarization layer 130, and then, the nano-photonic lens array 150 may be disposed on the protective layer.

The nano-photonic lens array 150 may be formed to color-separate incident light. For example, the nano-photonic lens array 150 may separate green light, blue light, and red light from the incident light and make the green, blue, and red light proceed in different paths. Also, the nano-photonic lens array 150 may be configured to also function as a lens for condensing the separated green light, the blue light, and the red light onto pixels. In particular, the nano-photonic lens array 150 may condense the blue light, from the incident light, on the second pixel 112, and condense the red light, from the incident light, on the third pixel 113. Also, the nano-photonic lens array 150 may condense the green light respectively to all of first to fourth pixels 111, 112, 113, and 114, in order not to degrade a resolution of a green channel image that is used to reconstruct the spatial resolution information.

To condense light of different colors on different pixels as described above, the nano-photonic lens array 150 may include a plurality of nano-structures NP that are regularly disposed according to a certain rule. Also, the nano-photonic lens array 150 may further include a dielectric layer DL filled among the plurality of nano-structures NP. In order for the nano-photonic lens array 150 to perform the above functions, the plurality of nano-structures NP of the nano-photonic lens array 150 may be variously formed.

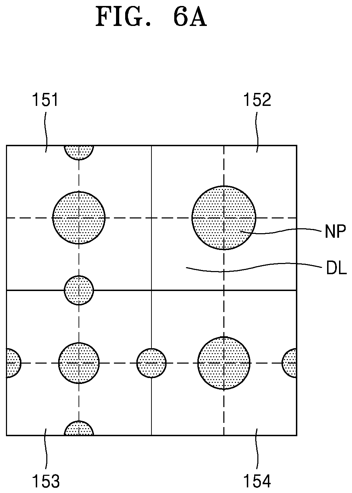

FIGS. 6A to 6D are plan views showing example structures of the nano-photonic lens array 150 shown in FIGS. 3A and 3B.

Referring to FIG. 6A, the nano-photonic lens array 150 may include a first lens 151 corresponding to the first pixel 111, a second lens 152 corresponding to the second pixel 112, a third lens 153 corresponding to the third pixel 113, and a fourth lens 154 corresponding to the fourth pixel 114. The first lens 151 is disposed to face the first pixel 111 in the third direction, the second lens 152 is disposed to face the second pixel 112 in the third direction, the third lens 153 is disposed to face the third pixel 113 in the third direction, and the fourth lens 154 may be disposed to face the fourth pixel 114 in the third direction. FIG.6A only shows one unit pattern, but the plurality of first lenses 151 and the plurality of second lenses 152 may be alternately disposed in the first direction, and the plurality of third lenses 153 and the plurality of fourth lenses 154 may be alternately disposed in the first direction on a cross-section taken at a different position in the second direction perpendicular to the first direction.

The nano-photonic lens array 150 may include a plurality of nano-structures NP disposed in the first to fourth lenses 151, 152, 153, and 154 to color-separate the incident light (separate the incident light based on color) and condense the separated light. The plurality of nano-structures NP may be disposed such that a phase of light transmitting through the nano-photonic lens array 150 is changed according to a position on the nano-photonic lens array 150. A phase profile of the transmitted light, which is implemented by the nano-photonic lens array 150, may be determined according to a width (or diameter) and a height of each of the nano-structures NP, and the arrangement period (or pitch) and arrangement type of the plurality of nano-structures NP. Also, the behavior of the light passing through the nano-photonic lens array 150 may be determined according to the phase profile of the transmitted light. For example, the plurality of nano-structures NP may be disposed to form a phase profile allowing the light transmitted through the nano-photonic lens array 150 to be separated according to wavelengths and condensed.

The nano-structures NP may each have a size that is less than a wavelength of visible light. The nano-structures NP may have a size that is less than, for example, the blue wavelength. For example, the cross-sectional width (or diameter) of the nano-structures NP may be less than 400 nm, 300 nm, or 200 nm. A height of the nano-structures NP may be about 500 nm to about 1500 nm, and may be greater than the cross-sectional width of the nano-structures NP.

The nano-structures NP may include a material having a relatively higher refractive index as compared with a peripheral material and having a relatively lower absorption ratio in the visible ray band. For example, the nano-structures NP may include c-Si, p-Si, a-Si and a Group III-V compound semiconductor (gallium phosphide (GaP), gallium nitride (GaN), gallium arsenide (GaAs) etc.), silicon carbide (SiC), titanium oxide (TiO₂), silicon nitride (SiN₃), zinc sulfide (ZnS), zinc selenide (ZnSe), silicon nitride (Si₃N₄), and/or a combination thereof. Periphery of the nano-structures NP may be filled with the dielectric layer DL having a relatively lower refractive index as compared with the nano-structures NP and have a relatively low absorbent ratio in the visible ray band. For example, the dielectric layer DL may be filled with siloxane-based spin on glass (SOG), silicon oxide (SiO₂), Si₃N₄, aluminum oxide (Al₂O₃), air, etc.

The refractive index of the nano-structures NP may be about 2.0 or greater with respect to light of about a 630 nm wavelength, and the refractive index of the dielectric layer DL may be about 1.0 to about 2.0 or less with respect to light of about a 630 nm wavelength. Also, a difference between the refractive indexes of the nano-structures NP and the refractive index of the dielectric layer DL may be about 0.5 or greater. The nano-structures NP having a difference in a refractive index between the refractive index of the peripheral material may change the phase of light that passes through the nano-structures NP. This is caused by phase delay that occurs due to the shape dimension of the sub-wavelength of the nanostructures NP, and a degree at which the phase is delayed may be determined by a detailed shape dimension and arrangement shape of the nanostructures NP.

In the example of FIG. 6A, the nano-structures NP of different diameters may be disposed at the centers of the first lens 151, the second lens 152, the third lens 153, and the fourth lens 154. For example, the nano-structure NP at the center of the second lens 152 may have the highest diameter, and the nano-structure NP at the center of the third lens 153 may have the smallest diameter. The nano-structures NP at the centers of the first lens 151 and the fourth lens 154 may have the same diameter which is greater than the diameter of the nano-structure NP disposed at the center of the third lens 153 and less than the diameter of the nano-structure NP disposed at the center of the second lens 152. Also, the nano-structures NP having the diameter less than that of the nano-structure NP at the center of the third lens 153 may be further disposed at a boundary between the first lens 151 and the third lens 153 and a boundary between the third lens 153 and the fourth lens 154.

In FIG. 6A, the nano-structures NP are shown to have cylindrical shapes, but cross-sectional shapes of the nano-structures NP are not limited thereto. For example, according to the design of the nano-photonic lens array 150, the nano-structures NP may be formed in pillar shapes having various different cross-sectional shapes such as, for example, rectangular shapes, triangular shapes, cross shapes, or elliptical shapes.

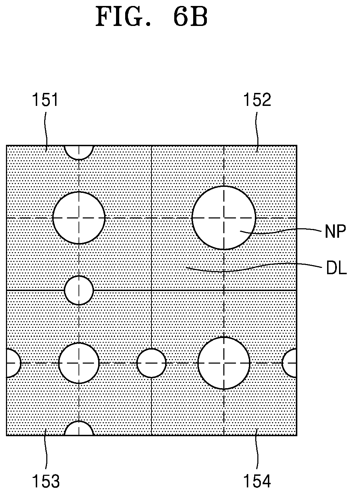

Also, referring to FIG. 6B, the nano-structures NP may have relatively low refractive index as compared with peripheral materials, and the dielectric layer DL may have a relatively high refractive index as compared with the nano-structures NP. For example, the nano-structures NP may be a plurality of holes formed in the dielectric layer DL having the relatively high refractive index. For example, the refractive index of the nano-structures NP may be less than the refractive index of the dielectric material DL.

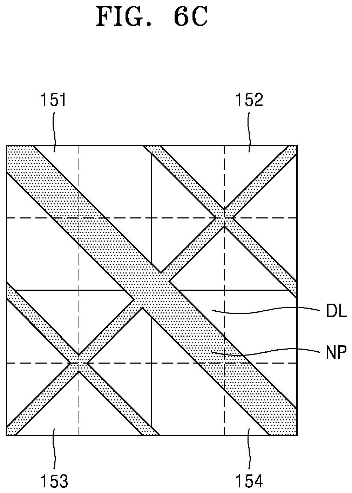

Referring to FIG. 6C, the nano-structures NP may each have a width less than the wavelength of the visible light, and may have a bar shape extending in the diagonal direction of the first to fourth lenses 151, 152, 153, and 154 or the first to fourth pixels 111, 112, 113, and 114 corresponding thereto. For example, the nano-structures NP may each include a first portion extending in the first diagonal direction across the first lens 151 and the fourth lens 154, a second portion extending in the second diagonal direction across the second lens 152 and the third lens 153, a third portion extending in the first diagonal direction in the second lens 152, and a fourth portion extending in the first diagonal direction in the third lens 153. In each of the portions, the widths of the nano-structures NP may be different from each other. The optical characteristics of the nano-photonic lens array 150 may be determined according to the direction in which the nano-structures NP extend and the widths of the nano-structures NP.

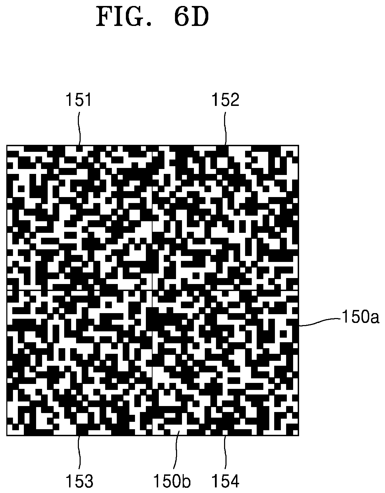

Referring to FIG. 6D, the nano-structures NP may be digitized binary patterns. For example, each of the first to fourth lenses 151, 152, 153, and 154 in the nano-photonic lens array 150 may have a binary pattern that is digitized in the arrangement of two-dimensional matrix form. In FIG. 6D, each of the first to fourth lenses 151, 152, 153, and 154 has the binary pattern that is digitized in 25x25 two-dimensional matrix-type arrangement as an example, but one or more embodiments are not limited thereto. The binary pattern shapes in the first to fourth lenses 151, 152, 153, and 154 may be different from one another. Each of the plurality of cells forming the two-dimensional matrix may have a size less than the wavelength of the visible ray. Also, each of the plurality of cells forming the two-dimensional matrix may be filled with one of a first dielectric material 150a having relatively high first refractive index and a second dielectric material 150b having a relatively low second refractive index. Also, at least one first dielectric material 150a having the first refractive index and at least one second dielectric material 150b having the second refractive index may be disposed in each row and column of the two-dimensional matrix.

FIGS. 6A to 6D show examples of the configuration of the nano-photonic lens array 150, and the nano-photonic lens array 150 may be formed in various shapes other than the examples shown in FIGS. 6A to 6D.

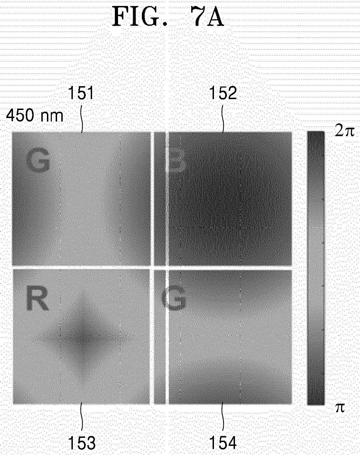

As described above, the nano-photonic lens array 150 may condense, from the incident light, the blue light only onto the second pixel 112 that is a portion of the entire pixels, red light only onto the third pixel 113 that is another portion of the entire pixels, and green light onto all of the first to fourth pixels 111, 112, 113, and 114, respectively. For example, the plurality of nano-structures NP of the nano-photonic lens array 150 may be disposed to condense, from the incident light, the blue light on the second pixel 112, the red light on the third pixel 113, and the green light on all of the first to fourth pixels 111, 112, 113, and 114. To this end, the nano-structures NP may be designed such that the blue light, green light, and red light may each have a certain target phase profile immediately after passing through the nano-photonic lens array 150, on a lower surface of the nano-photonic lens array 150. For example, FIGS. 7A to 7C show examples of the phase profiles of the blue light, green light, and red light after passing through the nano-photonic lens array 150 on a plane of the nano-photonic lens array 150.

Referring to FIG. 7A, the phase of the blue light immediately after passing through the nano-photonic lens array 150 may be gradually reduced in the form of a concentric circle from the center of the second lens 152. For example, in the incident light, the blue light having a wavelength of 450 nm may have a phase profile that is highest at the center of the second lens 152 and gradually decreases away from the center of the second lens 152, immediately after passing through the nano-photonic lens array 150, on the lower surface of the nano-photonic lens array 150. The phase of blue light in the first and second directions has a local minimum value around or at the centers of the first lens 151 and the fourth lens 154, and the phase of the blue light in the diagonal direction has a local minimum value around or at the center of the third lens 153. For example, when the highest phase of the blue light at the center of the second lens 152 is set as 2π, the local minimum phase of the blue light may be about 1.4π to about 1.6π around the centers of the first lens 151 and the fourth lens 154 and may be about 0.9π to about 1.3π around the center of the third lens 153.

In addition, the phase profile of the blue light may not indicate that a phase delay amount of the light that has passed through the center of the second lens 152 is the highest, and when the phase of the light that has passed through the center of the second lens 152 is set as 2π and a phase delay amount of the light that has passed through another point is greater and has a phase value of 2π or greater, the phase profile may denote a value remaining after subtracting 2nπ, that is, a wrapped phase profile. For example, when the phase of light that has passed through the center of the second lens 152 is set as 2π and the phase of light that has passed through the center of the third lens 153 is 3π, the phase in the third lens 153 may be a remaining π after subtracting 2π (n=1) from 3π.

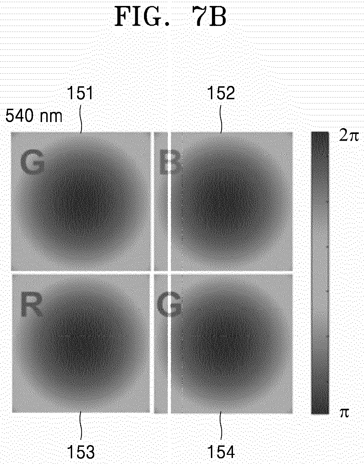

Referring to FIG. 7B, the phase of the green light immediately after passing through the nano-photonic lens array 150 may be gradually reduced in the form of the concentric circle from the center of each of the first to fourth lenses 151, 152, 153, and 154. For example, the green light having the wavelength of 540 nm in the incident light may have the phase profile that is highest at the center of each of the first to fourth lenses 151, 152, 153, and 154 immediately after passing through the nano-photonic lens array 150 and gradually decreases away from the center of each of the first to fourth lenses 151, 152, 153, and 154. The phase of the green light in the first and second directions has local minimum at a boundary between the first lens 151 and the second lens 152, a boundary between the first lens 151 and the third lens 153, a boundary between the fourth lens 154 and the second lens 152, and a boundary between the fourth lens 154 and the third lens 153, and the phase of the green light in the diagonal direction has a local minimum phase around or at apexes of each of the first to fourth lenses 151, 152, 153, and 154. For example, when the highest phase of the green light at the center of each of the first to fourth lenses 151, 152, 153, and 154 is set as 2π, the local minimum phase of the green light at the boundary between the first lens 151 and the second lens 152, the boundary between the first lens 151 and the third lens 153, the boundary between the fourth lens 154 and the second lens 152, and the boundary between the fourth lens 154 and the third lens 153 may be about 1.5π to about 1.7π, and the local minimum phase of the green light at the apexes of each of the first to fourth lenses 151, 152, 153, and 154 may be about π to about 1.3π.

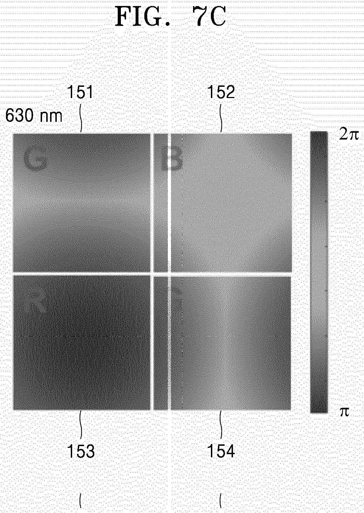

Referring to FIG. 7C, the phase of the red light immediately after passing through the nano-photonic lens array 150 may gradually reduce in the form of a concentric circle from the center of the third lens 153. For example, in the incident light, the red light having a wavelength of 630 nm may have a phase profile that is highest at the center of the third lens 153 and gradually decreases away from the center of the third lens 153, immediately after passing through the nano-photonic lens array 150, For example, on the lower surface of the nano-photonic lens array 150. The phase of red light in the first and second directions has a local minimum phase around or at the centers of the first lens 151 and the fourth lens 154, and the phase of the red light in the diagonal direction has a local minimum phase around or at the center of the second lens 152. For example, when the highest phase of the red light at the center of the third lens 153 is set to be 2π, the local minimum phase of the red light may be about 1.4π to about 1.6π around the centers of the first lens 151 and the fourth lens 154 and may be about 0.9π to about 1.3π around the center of the second lens 152.

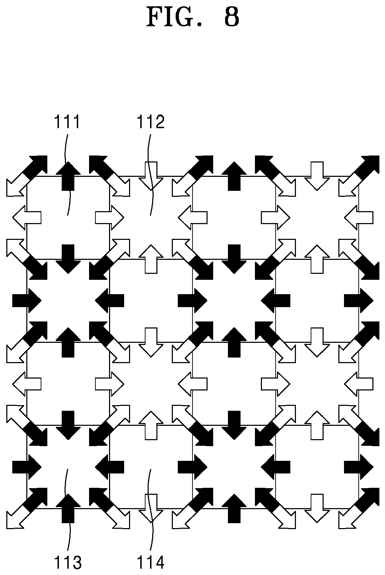

FIG. 8 is a diagram showing an example of passage of blue light and red light that are separated by the nano-photonic lens array 150 based on color. Referring to FIG. 8, in the incident light incident on the nano-photonic lens array 150, the blue light incident on surroundings of the second lens 152, as well as the blue light incident on the second lens 152 corresponding to the second pixel 112, may be also condensed onto the second pixel 112 by the nano-photonic lens array 150. Similarly, in the incident light incident on the nano-photonic lens array 150, the red light incident on the surroundings of the third lens 153, as well as the red light incident on the third lens 153 corresponding to the third pixel 113, may be condensed onto the third pixel 113 by the nano-photonic lens array 150. In addition, the green light incident on the first lens 152 may be condensed on the first pixel 111, the green light incident on the second lens 152 may be condensed on the second pixel 112, the green light incident on the third lens 153 may be condensed on the third pixel 113, and the green light incident on the fourth lens 154 may be condensed on the fourth pixel 114.

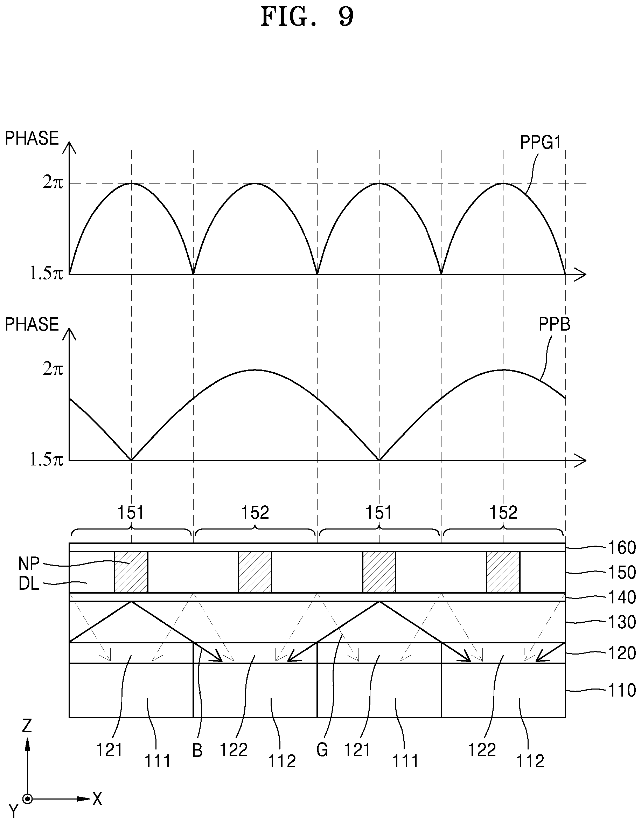

FIG. 9 is a diagram showing phase profiles of green light and blue light that have passed through the nano-photonic lens array 150 on a cross-section of FIG. 3A. Referring to FIG. 9, the green light that has passed through the nano-photonic lens array 150 may have a first green light phase profile PPG1 that is highest at the center of the first lens 151 and the second lens 152 in the first direction and decreases away from the centers of the first lens 151 and the second lens 152. For example, at the position immediately after passing through the nano-photonic lens array 150, that is, on the lower surface of the nano-photonic lens array 150 or the upper surface of the planarization layer 130, the phase of the green light may be highest at the center portions of the first lens 151 and the second lens 152 and gradually decreases in the form of a concentric circle away from the center portions of the first lens 151 and the second lens 152, and then, may have a local minimum value at the boundary between the first lens 151 and the second lens 152. Therefore, the first green light phase profile PPG1 may have the phase that is repeated at the same period as a lens arrangement period in the nano-photonic lens array 150.

Also, the blue light that has passed through the nano-photonic lens array 150 may have a blue light phase profile PPB that is highest at the center of the second lens 152 in the first direction and decreases away from the center of the second lens 152. For example, the phase of the blue light at the position immediately after passing through the nano-photonic lens array 150 may be highest at the center of the second lens and gradually decreases in the form of the concentric circle away from the center of the second lens 152, and then, may have a local minimum value at the center of the first lens 151. Therefore, the blue light phase profile PPB may have a phase that is repeated at a period that is about twice the lens arrangement period in the nano-photonic lens array 150.

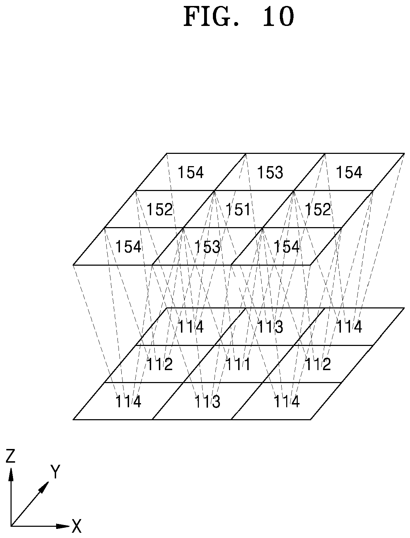

FIG. 10 is a diagram showing a direction of passage of green light incident on the nano-photonic lens array 150. Referring to FIG. 10, in the incident light that is incident on the nano-photonic lens array 150, the green light is condensed onto each pixel by the nano-photonic lens array 150. For example, the first green light phase profile PPG1 of the green light described above with reference to FIG. 9 may condense the green light that has passed through the first lens 151 onto the first pixel 111 corresponding to the first lens 151 and may condense the green light that has passed through the second lens 152 onto the second pixel 112 corresponding to the second lens 152. Therefore, each of the first lens 151 and the second lens 152 may be a green light condensing region for condensing the green light, and the size of the green light condensing region may be equal to that of the first lens 151 or the second lens 152.

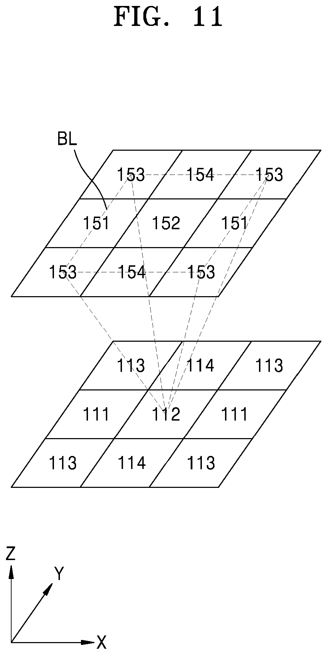

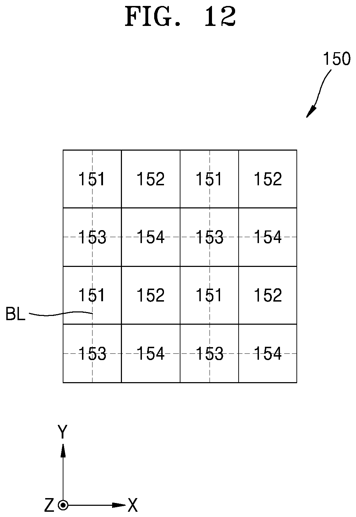

FIG. 11 shows an example of passage of blue light incident on a periphery of the second lens 152 in the nano-photonic lens array 150, and FIG. 12 shows an example of an array of a blue light condensing region formed by the nano-photonic lens array 150.

Referring to FIG. 11, in the incident light incident on the second lens 152 and the incident light incident on a portion of the first lens 151, a portion of the third lens 153, and a portion of the fourth lens 154, the blue light is condensed onto the second pixel 112 by the nano-photonic lens array 150. For example, according to the phase profile of the blue light described with reference to FIG. 9, the blue light that has passed through a blue light condensing region BL that is obtained by connecting the centers of four third lenses 153 that are adjacent to the second lens 152 at apexes may be condensed onto the second pixel 112. Therefore, as shown in FIG. 12, the nano-photonic lens array 150 may operate as a blue light condensing region BL array for condensing the blue light to the second pixel 112. The blue light condensing region BL has an area greater than that of the second pixel 112, e.g., may be 1.5 to 4 times greater. The blue light condensing region BL may partially overlap a portion of the green light condensing region and a portion of a red light condensing region RL that will be described later.

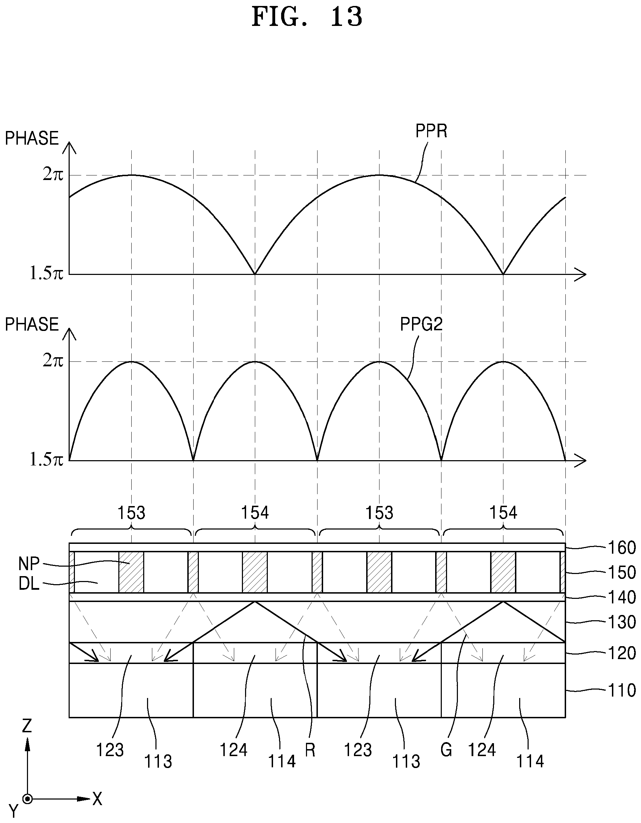

FIG. 13 is a diagram showing phase profiles of red light and green light that have passed through the nano-photonic lens array 150, on a cross-section of FIG. 3B. Referring to FIG. 13, the red light after passing through the nano-photonic lens array 150 may have a red light phase profile PPR that is highest at the center of the third lens 153 in the first direction and decreases away from the center of the third lens 153. For example, the phase of the red light at the position immediately after passing through the nano-photonic lens array 150 may be highest at the center of the third lens 153 and gradually decreases in the form of the concentric circle away from the center of the third lens 153, and then, may have a local minimum value at the center of the fourth lens 154. Therefore, the red light phase profile PPR may have a phase that is repeated at the period about twice the lens arrangement period in the nano-photonic lens array 150.

Also, the green light that has passed through the nano-photonic lens array 150 may have a second green light phase profile PPG2 that is highest at the centers of the third lens 153 and the fourth lens 154 in the first direction and decreases away from the centers of the third lens 153 and the fourth lens 154. For example, at the position immediately after passing through the nano-photonic lens array 150, that is, on the lower surface of the nano-photonic lens array 150 or the upper surface of the planarization layer 130, the phase of the green light may be highest at the centers of the third lens 153 and the fourth lens 154 and gradually decreases in the form of a concentric circle away from the center portions of the third lens 153 and the fourth lens 154, and then, may have a local minimum value at the boundary between the third lens 153 and the fourth lens 154. Therefore, the second green light phase profile PPG2 may have the phase that is repeated at the same period as a lens arrangement period in the nano-photonic lens array 150.

Referring back to FIG. 10, the second green light phase profile PPG2 of the green light described above with reference to FIG. 13 may condense the green light after passing through the third lens 153 onto the third pixel 113 corresponding to the third lens 153, and condense the green light after passing through the fourth lens 154 onto the fourth pixel 114 corresponding to the fourth lens 154. Therefore, each of the third lens 153 and the fourth lens 154 may be a green light condensing region for condensing the green light, and the size of the green light condensing region may be equal to that of the third lens 153 or the fourth lens 154.

Consequently, in the incident light that is incident on the nano-photonic lens array 150, the green light may be individually condensed onto the first pixel 111, the second pixel 112, the third pixel 113, and the fourth pixel 114 by the nano-photonic lens array 150. In this point of view, each of the first lens 151, the second lens 152, the third lens 153, and the fourth lens 154 of the nano-photonic lens array 150 may function as one micro-lens with respect to the green light. For example, the nano-photonic lens array 150 may condense the red light and the blue light after separation based on color, and condenses the green light without separation based on color. In addition, in the green light condensed onto the first pixel 111, the second pixel 112, the third pixel 113, and the fourth pixel 114, the green light condensed onto the first pixel 111 and the fourth pixel 114 is sensed by the first pixel 111 and the fourth pixel 114 after transmitting through the first color filter 121 and the fourth color filter 124, and the green light condensed onto the second pixel 112 and the third pixel 113 may be blocked by the first color filter 121 and the fourth color filter 124.

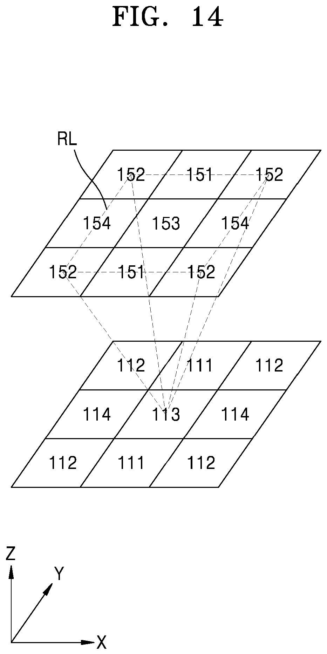

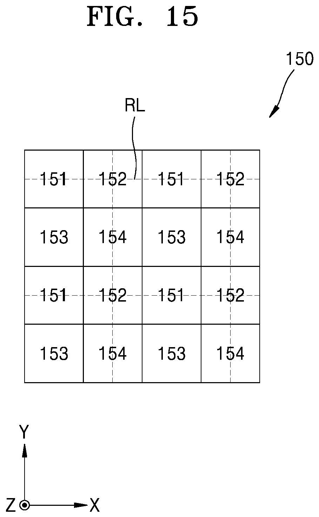

FIG. 14 shows an example of passage of red light incident on surroundings of the third lens 153 in the nano-photonic lens array 150, and FIG. 15 shows an example of an array of a red light condensing region formed by the nano-photonic lens array 150.

Referring to FIG. 14, among the incident light incident on the third lens 153 and the incident light incident on a portion of the first lens 151, a portion of the second lens 152, and a portion of the fourth lens 154, the red light is condensed onto the third pixel 113 by the nano-photonic lens array 150. For example, according to the phase profile of the red light described with reference to FIG. 13, the red light that has passed through a red light condensing region RL that is obtained by connecting the centers of four second lenses 152 that are adjacent to the third lens 153 at apexes may be condensed onto the third pixel 113. Therefore, as shown in FIG. 15, the nano-photonic lens array 150 may operate as a red light condensing region RL array for condensing the red light to the third pixel 113. The red light condensing region RL has an area greater than that of the third pixel 113, for example, may be 1.5 to 4 times greater. The red light condensing region RL may partially overlap a portion of the green light condensing region and a portion of the blue light condensing region BL.

As described above, the blue light incident on the second pixel 112 has passed through the blue light condensing region BL that is wider than the second pixel 112. Therefore, the blue light incident on the second pixel 112 may contain information about a spatial region around the second pixel 112, as well as the information about the spatial region corresponding to the second pixel 112. Similarly, the red light incident on the third pixel 113 may contain information about a spatial region around the third pixel 113, as well as the information about the spatial region corresponding to the third pixel 113. Therefore, the light utilization efficiency of the blue light and the red light increases, but the spatial resolutions of the blue channel image signal and the red channel image signal may degrade. In addition, the green light incident on the first pixel 111 and the fourth pixel 114 only contain the information about the spatial regions corresponding respectively to the first pixel 111 and the fourth pixel 114. Therefore, the light utilization efficiency of the green light does not increase, but the spatial resolution of the green channel image signal does not degrade.

In the Bayer pattern, the number of green pixels, for example, the first pixels 111 and the fourth pixels 114, is twice as many as the number of blue pixel, for example, the second pixels 112, and twice as many as the number of the red pixels, for example, the third pixels 113. For example, the green channel image signal has a spatial sampling rate that is twice higher than a spatial sampling rate of the blue channel image signal and a spatial sampling rate of the red channel image signal. Accordingly, the nano-photonic lens array 150 according to the example embodiment may be configured such that the spatial resolution of the green channel image signal having the relatively high spatial sampling rate is not degraded. For example, the nano-photonic lens array 150 may be formed so that the size of the green light condensing region is equal to the size of the first to fourth lenses 151, 152, 153, and 154 and may condense the green light onto each of the first to fourth pixels 111, 112, 113, and 114. Then, when a full-color image is generated through a demosaic algorithm, most of the spatial resolution information may be reconstructed by using the image signal about the light of first wavelength band, that is, the green channel image signal, having high spatial sampling rate. Demosaic process may be performed on the blue channel and the red channel by using the reconstructed information. Therefore, according to the example embodiment, the degradation in the resolution of the image generated by the image sensor 100 may be prevented or reduced while improving an average light utilization efficiency of the image sensor 1000.

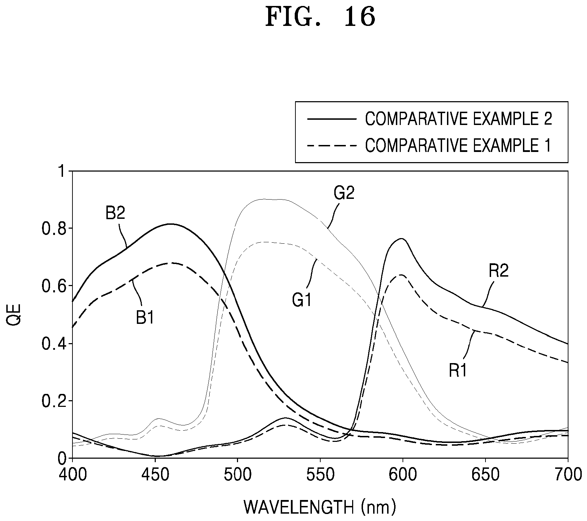

FIG. 16 is a graph showing an example of light utilization efficiency of an image sensor according to a related example. In FIG. 16, related example 1 denotes an image sensor only including a general color filter, and related example 2 denotes an image sensor including the nano-photonic lens array that is configured so that a size of the green light condensing region is greater than that of each lens like the red light and the blue light. Also, in FIG. 16, B1, G1, and R1 denote quantum efficiencies (QE) with respect to blue light, green light, and red light in the image sensor according to the related example 1, and B2, G2, and R2 denote QE with respect to blue light, green light, and red light in the image sensor according to the related example 2. Referring to FIG. 16, the image sensor including the nano-photonic lens array according to the related example 2 may have the light utilization efficiency, which is improved by about 20% as compared with the image sensor including the color filter according to the related example 1, with respect to all of the blue light, green light, and red light.

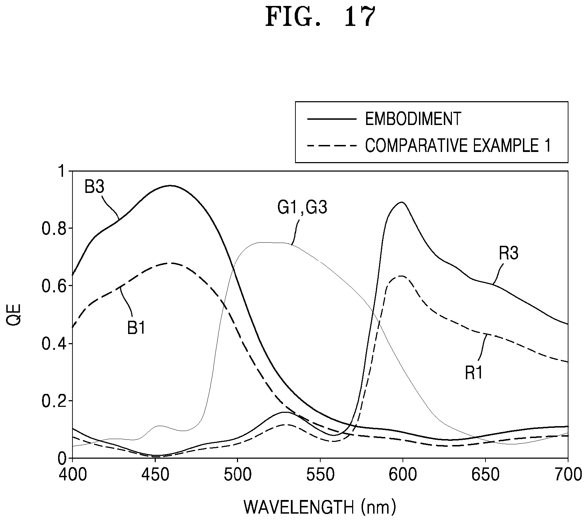

FIG. 17 is a graph showing an example of light utilization efficiency of an image sensor 1000 according to an example embodiment. In FIG. 17, related example 1 shows an image sensor only including a general color filter, and the example embodiment shows the image sensor 1000 including the nano-photonic lens array 150 described above. Also, in FIG. 17, B1, G1, and R1 denote QE with respect to the blue light, green light, and red light in the image sensor according to the related example 1, and B3, G3, and R3 denote QE with respect to the blue light, green light, and red light in the image sensor 1000 according to the example embodiment. Referring to FIG. 17, the image sensor 1000 according to the example embodiment may have nearly the same light utilization efficiency as that of the image sensor according to the related example 1, with respect to the green light. The image sensor 1000 according to the example embodiment may have the light utilization efficiency that is improved by about 40% as compared with the image sensor according to the related example 1, with respect to the blue light and the red light. Therefore, the average light utilization efficiency of the image sensor 1000 according to the example embodiment may be similar to that of the image sensor according to the related example 1.

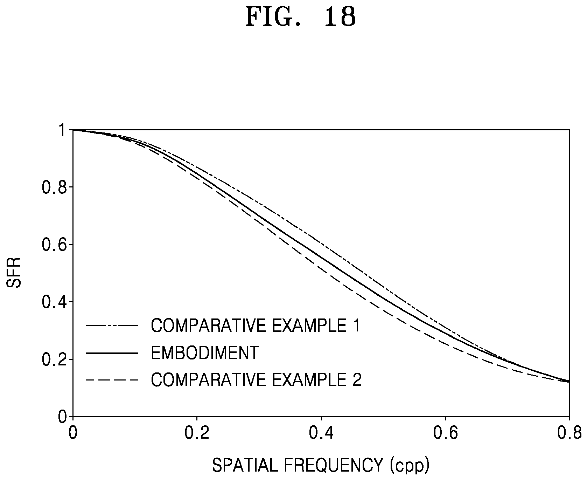

FIG. 18 is a graph showing an example of a modulation transfer function (MTF) curve of a full-color image obtained by applying an example image signal processing algorithm. In FIG. 18, a horizontal axis denotes a spatial frequency expressed in cycle per pixel (cpp) and a vertical axis denotes normalized spatial frequency response (SFR). In FIG. 18, a standard image signal processing algorithm based on Malvar demosaic is used. In the Malvar demosaic algorithm, resolutions of the red channel and the blue channel are interpolated by using resolution information of the green channel, and a larger weight is applied to the green channel as compared with the red channel and the blue channel during a process of extracting an MTF curve. Referring to FIG. 18, the image sensor only including the color filter according to the related example 1 has the highest SFR value, and the image sensor 1000 according to the example embodiment has the next highest SFR value, and the image sensor according to the related example 2 has the smallest SFR value. Therefore, the image sensor 1000 according to the example embodiment may have a greater light utilization efficiency as compared with that of the related example 1 and may have a higher resolution than that of the related example 2.

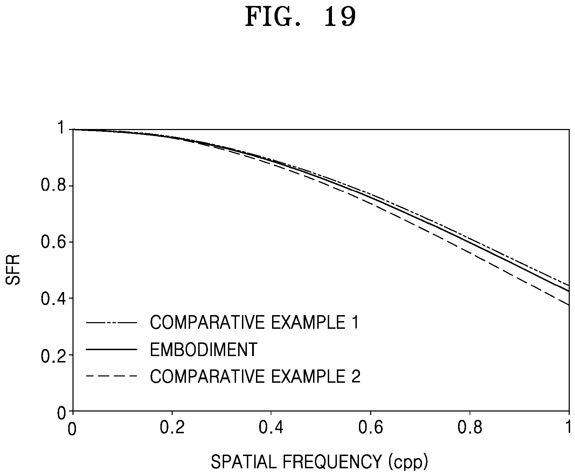

Also, FIG. 19 shows an example of an MTF curve of a full-color image obtained by applying another example image signal processing algorithm. In FIG. 19, the image signal processing algorithm applies a greater weight to the green channel, as compared with the Malvar demosaic algorithm. Referring to FIG. 19, the image sensor only including the color filter according to the related example 1 has the highest SFR value, and the image sensor 1000 according to the example embodiment has the next highest SFR value, and the image sensor according to the related example 2 has the smallest SFR value. However, as compared with FIG. 18, the SFR value of the image sensor 1000 according to the example embodiment becomes closer to the SFR value of the image sensor according to the related example 1. Therefore, when the demosaic algorithm is advanced, the SFR value of the image sensor 1000 according to the example embodiment may not be much different from the SFR value of the image sensor according to the related example 1. Then, the degradation in the resolution may be reduced while improving the light utilization efficiency in the image sensor 1000 according to the example embodiment.

In the above description, the Bayer pattern having two green pixels, one blue pixel, and one red pixel is described in detail. However, the above principle may also apply to the RYB type arrangement and CMY type arrangement shown in FIGS. 2B and 2C. For example, in the RYB arrangement, the nano-photonic lens array 150 may condense yellow light onto all of the pixels without color separation, and may only color-separate the blue light and the red light and condense the blue light and the red light onto the blue pixel and the red pixel, respectively. Also, in the CMY arrangement, the nano-photonic lens array 150 may condense the yellow light onto all of the pixels without color separation, and may only color-separate cyan light and magenta light and condense the cyan light and the magenta light respectively onto the cyan pixel and magenta pixel. In this case, when a full-color image is generated through the demosaic algorithm, the spatial resolution information may be reconstructed by using an image signal of a yellow channel having high spatial sampling rate.

As described above, the image sensor 1000 according to the example embodiment may have the improved light utilization efficiency and reduced degradation in the resolution. Therefore, a size of one pixel or size of independent photosensitive cells in the pixel of the image sensor 1000 may be reduced. Therefore, the image sensor 1000 having relatively high resolution may be provided. The image sensor 1000 according to the example embodiment may form a camera module along with a module lens of various functions and may be utilized in various electronic devices.

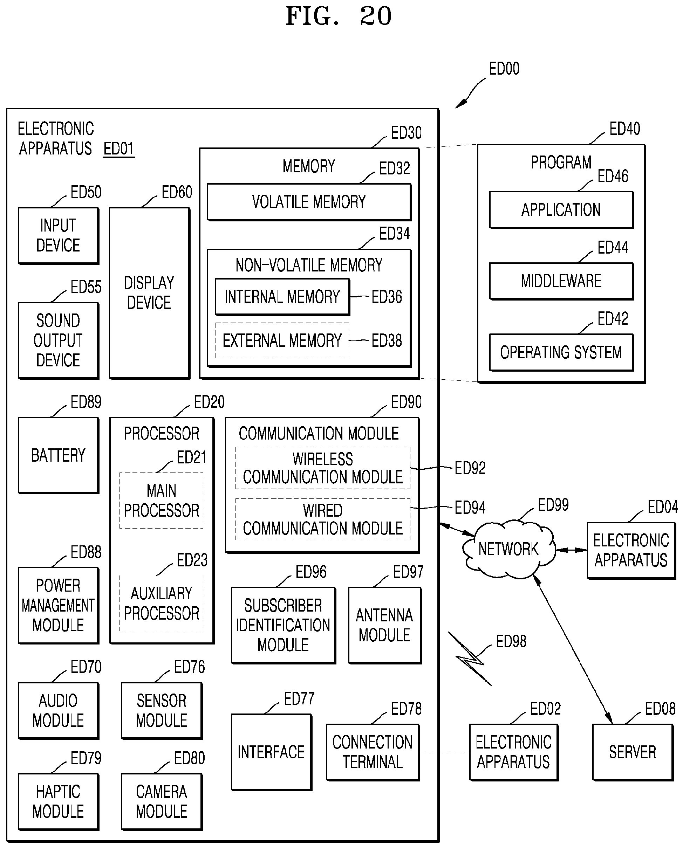

FIG. 20 is a block diagram showing an example of an electronic apparatus ED01 including the image sensor 1000. Referring to FIG. 20, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic apparatus ED01 connected to the processor ED20 by executing software (program ED40, etc.), and may perform various data processes or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34 including internal memory ED36 and external memory ED38. The processor ED20 may include a main processor ED21 (central processing unit, application processor, etc.) and an auxiliary processor ED23 (graphic processing unit, image signal processor, sensor hub processor, communication processor, etc.) that may be operated independently from or along with the main processor ED21. The auxiliary processor ED23 may use less power than that of the main processor ED21, and may perform specified functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (display device ED60, sensor module ED76, communication module ED90, etc.) of the elements in the electronic apparatus ED01. The auxiliary processor ED23 (image signal processor, communication processor, etc.) may be implemented as a part of another element (camera module ED80, communication module ED90, etc.) that is functionally related thereto.

The memory ED30 may store various data required by the elements (processor ED20, sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the elements (processor ED20, etc.) of the electronic apparatus ED01, from outside (user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (pressure sensor, etc.) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (electronic apparatus ED02, etc.). The connection terminal ED78 may include an HDMI connector, a USB connector, an SD card connector, and/or an audio connector (headphone connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (electronic apparatus ED02, electronic apparatus ED04, server ED08, etc.), and execution of communication through the established communication channel. The communication module ED90 may be operated independently from the processor ED20 (application processor, etc.), and may include one or more communication processors that support the direct communication and/or the wireless communication. The communication module ED90 may include a wireless communication module ED92 (cellular communication module, a short-range wireless communication module, a global navigation satellite system (GNSS) communication module) and/or a wired communication module ED94 (local area network (LAN) communication module, a power line communication module, etc.). From among the communication modules, a corresponding communication module may communicate with another electronic apparatus via a first network ED09 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

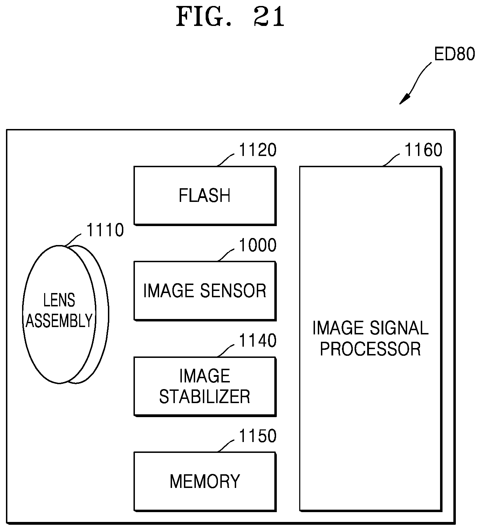

FIG. 21 is a block diagram showing an example of the camera module ED80 included in the electronic apparatus ED01 of FIG. 20. Referring to FIG. 21, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal distance, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus 1101 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high-resolution data, etc.) is stored in the memory 1150, and a low-resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

The image signal processor 1160 may perform image treatment on the image obtained through the image sensor 1000 or the image data stored in the memory 1150. The image treatments may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80. Also, the image signal processor 1160 may generate a full-color image by executing the above demosaic algorithm. For example, when the demosaic algorithm is executed to generate the full-color image, the image signal processor 1160 may reconstruct most of the spatial resolution information by using an image signal of a green channel or yellow channel having high spatial sampling rate.

The image processed by the image signal processor 1160 may be stored again in the memory 1150 for additional process, or may be provided to an external element of the camera module ED80 (for example, the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image treatment by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 so that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 21, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

## Claims

1. An image sensor (1000) comprising:
a sensor substrate (110) comprising a plurality of pixels (111, 112, 113, 114) configured to sense light;
a nano-photonic lens array (150) comprising a plurality of nano-structures (NP) configured to separate incident light based on color and condense the color-separated incident light onto the plurality of pixels; and
a color filter layer (120) between the sensor substrate and the nano-photonic lens array, the color filter layer comprising a plurality of color filters (121, 122, 123, 124), each color filter of the plurality of color filters being configured to transmit one of light of a first wavelength band, light of a second wavelength band, and light of a third wavelength band,
wherein a number of color filters of the plurality of color filters configured to transmit the light of the first wavelength band (121, 124) is greater than a number of color filters of the plurality of color filters configured to transmit the light of the second wavelength band (122) and a number of color filters of the plurality of color filters configured to transmit the light of the third wavelength band (123), and
wherein the plurality of nano-structures are further configured to color-separate and condense the light of the second wavelength band and the light of the third wavelength band, and condense the light of the first wavelength band without color-separation;
wherein the plurality of nano-structures are further configured to:
condense the light of the first wavelength band onto all of the plurality of pixels,
condense the light of the second wavelength band onto a first number of pixels of the plurality of pixels, and
condense the light of the third wavelength band onto a second number of pixels of the plurality of pixels other than the first number of pixels.

2. The image sensor of claim 1, wherein each of the plurality of nano-structures has a pillar shape and is smaller than a range of wavelengths of visible light.

3. The image sensor of claim 1, wherein each of the plurality of nano-structures has a width less than wavelengths of visible light and has a bar shape extending in a diagonal direction of the plurality of pixels.

4. The image sensor of any preceding claim, wherein the plurality of nano-structures have a binary pattern that is digitized in a two-dimensional matrix, and each of a plurality of cells forming the two-dimensional matrix is filled with one of a first dielectric material having a first refractive index and a second dielectric material having a second refractive index that is lower than the first refractive index.

5. The image sensor of any preceding claim, wherein the plurality of pixels comprise a first pixel, a second pixel, a third pixel, and a fourth pixel,
wherein the plurality of color filters comprise a first color filter corresponding to the first pixel, a second color filter corresponding to the second pixel, a third color filter corresponding to the third pixel, and a fourth color filter corresponding to the fourth pixel,
wherein the nano-photonic lens array comprises a first lens corresponding to the first pixel, a second lens corresponding to the second pixel, a third lens corresponding to the third pixel, and a fourth lens corresponding to the fourth pixel,
wherein the first color filter and the fourth color filter are configured to transmit the light of the first wavelength band, the second color filter is configured to transmit the light of the second wavelength band, and the third color filter is configured to transmit the light of the third wavelength band, and
wherein the plurality of nano-structures are disposed in the first lens, the second lens, the third lens, and the fourth lens to separate and condense the incident light.

6. The image sensor of claim 5, wherein the plurality of nano-structures are further configured to:
condense the light of the first wavelength band onto the first pixel, the second pixel, the third pixel, and the fourth pixel,
condense the light of the second wavelength band onto the second pixel, and
condense the light of the third wavelength band onto the third pixel.

7. The image sensor of claim 6, wherein a phase profile of the light of the first wavelength band immediately after passing through the nano-photonic lens array has a phase repeated at a period that is the same as a lens arrangement period in the nano-photonic lens array, and
wherein a phase profile of the light of the second wavelength band and a phase profile of the light of the third wavelength band immediately after passing through the nano-photonic lens array have phases repeated at a period that is twice the lens arrangement period in the nano-photonic lens array.

8. The image sensor of claim 6, wherein a phase profile of the light of the first wavelength band immediately after passing through the nano-photonic lens array decreases gradually in a form of a concentric circle from a center of each of the first lens, the second lens, the third lens, and the fourth lens.

9. The image sensor of claim 8, wherein a phase of the light of the first wavelength band has a minimum phase at a boundary between the first lens and the second lens, a boundary between the first lens and the third lens, a boundary between the fourth lens and the second lens, and a boundary between the fourth lens and the third lens, and has a minimum phase at apexes in each of the first lens, the second lens, the third lens, and the fourth lens, and optionally wherein, based on a highest phase of the light of the first wavelength band being set as 2π, the minimum phase at the boundary between the first lens and the second lens, the boundary between the first lens and the third lens, the boundary between the fourth lens and the second lens, and the boundary between the fourth lens and the third lens is 1.5π to 1.7π, and the minimum phase at apexes of each of the first lens, the second lens, the third lens, and the fourth lens is π to 1.3π.

10. The image sensor of claim 6, wherein a phase profile of the light of the second wavelength band immediately after passing through the nano-photonic lens array gradually decreases from a center of the second lens in a form of a concentric circle, and optionally wherein a phase of the light of the second wavelength band has a minimum phase at a center of each of the first lens, the third lens, and the fourth lens, and further optionally wherein, based on a highest phase of the light of the second wavelength band being set as 2π, the minimum phase at the center of each of the first lens and the fourth lens is 1.4π to 1.6π, and the minimum phase at the center of the third lens is 0.9π to 1.3π.

11. The image sensor of claim 6, wherein a phase profile of the light of the third wavelength band immediately after passing through the nano-photonic lens array gradually decreases from a center of the third lens in a form of a concentric circle, and optionally wherein the phase profile of the light of the third wavelength band has a minimum phase at a center of each of the first lens, the second lens, and the fourth lens, and further optionally wherein, based on a highest phase of the light of the third wavelength band being set as 2π, the minimum phase at the center of the first lens and the center of the fourth lens is 1.4π to 1.6π, and the minimum phase at the center of the second lens is 0.9π to 1.3π.

12. The image sensor of any of claims 6 to 11, wherein each of the plurality of nano-structures has a pillar shape and is smaller than a range of wavelengths of visible light,
wherein the nano-structures are respectively disposed at a center of each of the first lens, the second lens, the third lens, and the fourth lens included in the nano-photonic lens array,
wherein a diameter of a nano-structure disposed at the center of the first lens is equal to a diameter of a nano-structure disposed at the center of the fourth lens, and
wherein the diameter of the nano-structure disposed at the center of the first lens, a diameter of a nano-structure disposed at the center of the second lens, and a diameter of a nano-structure disposed at the center of the third lens are different from each other.

13. The image sensor of any preceding claim, further comprising:
a planarization layer between the color filter layer and the nano-photonic lens array.

14. An electronic apparatus (ED01) comprising:
a lens assembly configured to form an optical image of a subject;
an image sensor (1000) according to any preceding claim configured to convert the optical image formed by the lens assembly into an electrical signal; and
a processor (ED20) configured to process a signal generated by the image sensor.

## Patentansprüche

1. Bildsensor (1000), umfassend:
ein Sensorsubstrat (110), das eine Vielzahl von Pixeln (111, 112, 113, 114) umfasst, die zum Erfassen von Licht konfiguriert sind;
eine nanophotonische Linsenanordnung (150), die eine Vielzahl von Nanostrukturen (NP) umfasst, die dazu konfiguriert sind, auftreffendes Licht basierend auf der Farbe zu trennen und das farblich getrennte auftreffende Licht auf die Vielzahl von Pixeln zu konzentrieren; und
eine Farbfilterschicht (120) zwischen dem Sensorsubstrat und der nanophotonischen Linsenanordnung, wobei die Farbfilterschicht eine Vielzahl von Farbfiltern (121, 122, 123, 124) umfasst, wobei jeder Farbfilter der Vielzahl von Farbfiltern dazu konfiguriert ist, eines von Licht eines ersten Wellenlängenbandes, Licht eines zweiten Wellenlängenbandes und Licht eines dritten Wellenlängenbandes zu übertragen,
wobei eine Anzahl von Farbfiltern der Vielzahl von Farbfiltern, die dazu konfiguriert sind, das Licht des ersten Wellenlängenbandes (121, 124) zu übertragen, größer als eine Anzahl von Farbfiltern der Vielzahl von Farbfiltern, die dazu konfiguriert sind, das Licht des zweiten Wellenlängenbandes (122) zu übertragen, und eine Anzahl von Farbfiltern der Vielzahl von Farbfiltern, die dazu konfiguriert sind, das Licht des dritten Wellenlängenbandes (123) zu übertragen, ist und
wobei die Vielzahl von Nanostrukturen ferner dazu konfiguriert ist, das Licht des zweiten Wellenlängenbandes und das Licht des dritten Wellenlängenbandes farblich zu trennen und zu konzentrieren und das Licht des ersten Wellenlängenbandes ohne Farbtrennung zu konzentrieren;
wobei die Vielzahl von Nanostrukturen ferner zu Folgendem konfiguriert ist:
Konzentrieren des Lichts des ersten Wellenlängenbandes auf alle der Vielzahl von Pixeln,
Konzentrieren des Lichts des zweiten Wellenlängenbandes auf eine erste Anzahl von Pixeln der Vielzahl von Pixeln und
Konzentrieren des Lichts des dritten Wellenlängenbandes auf eine zweite Anzahl von Pixeln der Vielzahl von Pixeln, die sich von der ersten Anzahl von Pixeln unterscheidet.

2. Bildsensor nach Anspruch 1, wobei jede aus der Vielzahl von Nanostrukturen eine Säulenform aufweist und kleiner als ein Bereich von Wellenlängen von sichtbarem Licht ist.

3. Bildsensor nach Anspruch 1, wobei jede aus der Vielzahl von Nanostrukturen eine Breite aufweist, die kleiner als Wellenlängen von sichtbarem Licht ist, und eine Stabform aufweist, die sich in einer diagonalen Richtung aus der Vielzahl von Pixeln erstreckt.

4. Bildsensor nach einem vorhergehenden Anspruch, wobei die Vielzahl von Nanostrukturen ein binäres Muster aufweist, das in einer zweidimensionalen Matrix digitalisiert ist, und jede von einer Vielzahl von Zellen, die die zweidimensionale Matrix ausbilden, mit einem von einem ersten dielektrischen Material, das einen ersten Brechungsindex aufweist, und einem zweiten dielektrischen Material, das einen zweiten Brechungsindex aufweist, der niedriger als der erste Brechungsindex ist, gefüllt ist.

5. Bildsensor nach einem vorhergehenden Anspruch, wobei die Vielzahl von Pixeln ein erstes Pixel, ein zweites Pixel, ein drittes Pixel und ein viertes Pixel umfasst,
wobei die Vielzahl von Farbfiltern einen ersten Farbfilter, der dem ersten Pixel entspricht, einen zweiten Farbfilter, der dem zweiten Pixel entspricht, einen dritten Farbfilter, der dem dritten Pixel entspricht, und einen vierten Farbfilter, der dem vierten Pixel entspricht, umfasst,
wobei die nanophotonische Linsenanordnung eine erste Linse, die dem ersten Pixel entspricht, eine zweite Linse, die dem zweiten Pixel entspricht, eine dritte Linse, die dem dritten Pixel entspricht, und eine vierte Linse, die dem vierten Pixel entspricht, umfasst,
wobei der erste Farbfilter und der vierte Farbfilter dazu konfiguriert sind, das Licht des ersten Wellenlängenbandes zu übertragen, der zweite Farbfilter dazu konfiguriert ist, das Licht des zweiten Wellenlängenbandes zu übertragen, und der dritte Farbfilter dazu konfiguriert ist, das Licht des dritten Wellenlängenbandes zu übertragen, und
wobei die Vielzahl von Nanostrukturen in der ersten Linse, der zweiten Linse, der dritten Linse und der vierten Linse angeordnet ist, um das auftreffende Licht zu trennen und zu konzentrieren.

6. Bildsensor nach Anspruch 5, wobei die Vielzahl von Nanostrukturen ferner zu Folgendem konfiguriert ist:
Konzentrieren des Lichts des ersten Wellenlängenbandes auf das erste Pixel, das zweite Pixel, das dritte Pixel und das vierte Pixel,
Konzentrieren des Lichts des zweiten Wellenlängenbandes auf das zweite Pixel und
Konzentrieren des Lichts des dritten Wellenlängenbandes auf das dritte Pixel.

7. Bildsensor nach Anspruch 6, wobei ein Phasenprofil des Lichts des ersten Wellenlängenbandes unmittelbar nach dem Durchgehen durch die nanophotonische Linsenanordnung eine Phase aufweist, die sich in einer Periode wiederholt, die die gleiche wie eine Linsenaufstellungsperiode in der nanophotonischen Linsenanordnung ist, und
wobei ein Phasenprofil des Lichts des zweiten Wellenlängenbandes und ein Phasenprofil des Lichts des dritten Wellenlängenbandes unmittelbar nach dem Durchgehen durch die nanophotonische Linsenanordnung Phasen aufweisen, die sich in einer Periode wiederholen, die doppelt so groß wie die Linsenaufstellungsperiode in der nanophotonischen Linsenanordnung ist.

8. Bildsensor nach Anspruch 6, wobei ein Phasenprofil des Lichts des ersten Wellenlängenbandes unmittelbar nach dem Durchgehen durch die nanophotonische Linsenanordnung allmählich in einer Form eines konzentrischen Kreises von einer Mitte jeder von der ersten Linse, der zweiten Linse, der dritten Linse und der vierten Linse abnimmt.

9. Bildsensor nach Anspruch 8, wobei eine Phase des Lichts des ersten Wellenlängenbandes eine Minimumphase an einer Grenze zwischen der ersten Linse und der zweiten Linse, einer Grenze zwischen der ersten Linse und der dritten Linse, einer Grenze zwischen der vierten Linse und der zweiten Linse und einer Grenze zwischen der vierten Linse und der dritten Linse aufweist und eine Minimumphase an Spitzen in jeder von der ersten Linse, der zweiten Linse, der dritten Linse und der vierten Linse aufweist, und optional wobei, basierend darauf, dass eine höchste Phase des Lichts des ersten Wellenlängenbandes als 2π eingestellt ist, die Minimumphase an der Grenze zwischen der ersten Linse und der zweiten Linse, der Grenze zwischen der ersten Linse und der dritten Linse, der Grenze zwischen der vierten Linse und der zweiten Linse und der Grenze zwischen der vierten Linse und der dritten Linse 1,5π bis 1,7π beträgt, und die Minimumphase an Spitzen jeder von der ersten Linse, der zweiten Linse, der dritten Linse und der vierten Linse π bis 1,3π beträgt.

10. Bildsensor nach Anspruch 6, wobei ein Phasenprofil des Lichts des zweiten Wellenlängenbandes unmittelbar nach dem Durchgehen durch die nanophotonische Linsenanordnung allmählich von einer Mitte der zweiten Linse in einer Form eines konzentrischen Kreises abnimmt, und optional wobei eine Phase des Lichts des zweiten Wellenlängenbandes eine Minimumphase in einer Mitte jeder von der ersten Linse, der dritten Linse und der vierten Linse aufweist, und ferner optional wobei, basierend darauf, dass eine höchste Phase des Lichts des zweiten Wellenlängenbandes als 2π eingestellt ist, die Minimumphase in der Mitte jeder von der ersten Linse und der vierten Linse 1,4π bis 1,6π beträgt und die Minimumphase in der Mitte der dritten Linse 0,9π bis 1,3π beträgt.

11. Bildsensor nach Anspruch 6, wobei ein Phasenprofil des Lichts des dritten Wellenlängenbandes unmittelbar nach dem Durchgehen durch die nanophotonische Linsenanordnung allmählich von einer Mitte der dritten Linse in einer Form eines konzentrischen Kreises abnimmt, und optional wobei das Phasenprofil des Lichts des dritten Wellenlängenbandes eine Minimumphase in einer Mitte jeder von der ersten Linse, der zweiten Linse und der vierten Linse aufweist, und ferner optional wobei, basierend darauf, dass eine höchste Phase des Lichts des dritten Wellenlängenbandes als 2π eingestellt ist, die Minimumphase in der Mitte der ersten Linse und der Mitte der vierten Linse 1,4π bis 1,6π beträgt und die Minimumphase in der Mitte der zweiten Linse 0,9π bis 1,3π beträgt.

12. Bildsensor nach einem der Ansprüche 6 bis 11, wobei jede aus der Vielzahl von Nanostrukturen eine Säulenform aufweist und kleiner als ein Bereich von Wellenlängen von sichtbarem Licht ist,
wobei die Nanostrukturen jeweils in einer Mitte jeder von der ersten Linse, der zweiten Linse, der dritten Linse und der vierten Linse, die in der nanophotonischen Linsenanordnung enthalten sind, angeordnet sind,
wobei ein Durchmesser einer Nanostruktur, die in der Mitte der ersten Linse angeordnet ist, gleich einem Durchmesser einer Nanostruktur ist, die in der Mitte der vierten Linse angeordnet ist, und
wobei sich der Durchmesser der Nanostruktur, die in der Mitte der ersten Linse angeordnet ist, ein Durchmesser einer Nanostruktur, die in der Mitte der zweiten Linse angeordnet ist, und ein Durchmesser einer Nanostruktur, die in der Mitte der dritten Linse angeordnet ist, voneinander unterscheiden.

13. Bildsensor nach einem vorhergehenden Anspruch, ferner umfassend:
eine Planarisierungsschicht zwischen der Farbfilterschicht und der nanophotonischen Linsenanordnung.

14. Elektronische Vorrichtung (ED01), umfassend:
eine Linsenbaugruppe, die dazu konfiguriert ist, ein optisches Bild eines Subjekts auszubilden;
einen Bildsensor (1000) nach einem vorhergehenden Anspruch, der dazu konfiguriert ist, das optische Bild, das durch die Linsenbaugruppe ausgebildet wird, in ein elektrisches Signal umzuwandeln; und
einen Prozessor (ED20), der dazu konfiguriert ist, ein durch den Bildsensor erzeugtes Signal zu verarbeiten.

## Revendications

1. Capteur d'image (1000) comprenant :
un substrat de capteur (110) comprenant une pluralité de pixels (111, 112, 113, 114) configurés pour détecter la lumière ;
un réseau de lentilles nanophotoniques (150) comprenant une pluralité de nanostructures (NP) configurées pour séparer la lumière incidente en fonction de la couleur et condenser la lumière incidente à couleur séparée sur la pluralité de pixels ; et
une couche de filtre de couleur (120) entre le substrat de capteur et le réseau de lentilles nanophotoniques, la couche de filtre de couleur comprenant une pluralité de filtres de couleur (121, 122, 123, 124), chaque filtre de couleur de la pluralité de filtres de couleur étant configuré pour transmettre l'une d'une lumière d'une première bande de longueur d'onde, d'une lumière d'une deuxième bande de longueur d'onde, et d'une lumière d'une troisième bande de longueur d'onde,
dans lequel un nombre de filtres de couleur de la pluralité de filtres de couleur configurés pour transmettre la lumière de la première bande de longueur d'onde (121, 124) est supérieur à un nombre de filtres de couleur de la pluralité de filtres de couleur configurés pour transmettre la lumière de la deuxième bande de longueur d'onde (122) et à un nombre de filtres de couleur de la pluralité de filtres de couleur configurés pour transmettre la lumière de la troisième bande de longueur d'onde (123), et
dans lequel la pluralité de nanostructures sont en outre configurées pour séparer les couleurs et pour condenser la lumière de la deuxième bande de longueur d'onde et la lumière de la troisième bande de longueurs d'onde, et pour condenser la lumière de la première bande de longueur d'onde sans séparation de couleurs ;
dans lequel la pluralité de nanostructures sont en outre configurées pour :
condenser la lumière de la première bande de longueur d'onde sur l'ensemble de la pluralité de pixels,
condenser la lumière de la deuxième bande de longueur d'onde sur un premier nombre de pixels de la pluralité de pixels, et
condenser la lumière de la troisième bande de longueur d'onde sur un deuxième nombre de pixels de la pluralité de pixels autre que le premier nombre de pixels.

2. Capteur d'image selon la revendication 1, dans lequel chacune de la pluralité de nanostructures a une forme de pilier et est inférieure à une plage de longueurs d'onde de lumière visible.

3. Capteur d'images selon la revendication 1, dans lequel chacune de la pluralité de nanostructures a une largeur inférieure à des longueurs d'onde de lumière visible et a une forme de barre s'étendant dans une direction diagonale de la pluralité de pixels.

4. Capteur d'image selon l'une quelconque des revendications précédentes, dans lequel la pluralité de nanostructures présentent un motif binaire qui est numérisé en une matrice bidimensionnelle, et chacune d'une pluralité de cellules formant la matrice bidimensionnelle est remplie de l'un d'un premier matériau diélectrique ayant un premier indice de réfraction et d'un second matériau diélectrique ayant un second indice de réfraction inférieur au premier indice de réfraction.

5. Capteur d'image selon l'une quelconque des revendications précédentes, dans lequel la pluralité de pixels comprennent un premier pixel, un deuxième pixel, un troisième pixel et un quatrième pixel,
dans lequel la pluralité de filtres de couleur comprennent un premier filtre de couleur correspondant au premier pixel, un deuxième filtre de couleur correspondant au deuxième pixel, un troisième filtre de couleur correspondant au troisième pixel, et un quatrième filtre de couleur correspondant au quatrième pixel,
dans lequel le réseau de lentilles nanophotoniques comprend une première lentille correspondant au premier pixel, une deuxième lentille correspondant au deuxième pixel, une troisième lentille correspondant au troisième pixel, et une quatrième lentille correspondant au quatrième pixel,
dans lequel le premier filtre de couleur et le quatrième filtre de couleur sont configurés pour transmettre la lumière de la première bande de longueur d'onde, le deuxième filtre de couleur est configuré pour transmettre la lumière de la deuxième bande de longueur d'onde, et le troisième filtre de couleur est configuré pour transmettre la lumière de la troisième bande de longueur d'onde, et
dans lequel la pluralité de nanostructures sont disposées dans la première lentille, la deuxième lentille, la troisième lentille et la quatrième lentille pour séparer et condenser la lumière incidente.

6. Capteur d'image selon la revendication 5, dans lequel la pluralité de nanostructures sont en outre configurées pour :
condenser la lumière de la première bande de longueur d'onde sur le premier pixel, le deuxième pixel, le troisième pixel et le quatrième pixel,
condenser la lumière de la deuxième bande de longueur d'onde sur le deuxième pixel, et condenser la lumière de la troisième bande de longueur d'onde sur le troisième pixel.

7. Capteur d'image selon la revendication 6, dans lequel un profil de phase de la lumière de la première bande de longueur d'onde immédiatement après avoir traversé le réseau de lentilles nanophotoniques présente une phase répétée à une période qui est la même qu'une période d'agencement de lentilles dans le réseau de lentilles nanophotoniques, et
dans lequel un profil de phase de la lumière de la deuxième bande de longueur d'onde et un profil de phase de la lumière de la troisième bande de longueur d'onde immédiatement après avoir traversé le réseau de lentilles nanophotoniques présentent des phases répétées à une période qui est le double de la période d'agencement de lentilles dans le réseau de lentilles nanophotoniques.

8. Capteur d'images selon la revendication 6, dans lequel un profil de phase de la lumière de la première bande de longueur d'onde immédiatement après avoir traversé le réseau de lentilles nanophotoniques diminue progressivement sous la forme d'un cercle concentrique à partir d'un centre de chacune de la première lentille, la deuxième lentille, la troisième lentille et la quatrième lentille.

9. Capteur d'image selon la revendication 8, dans lequel une phase de la lumière de la première bande de longueur d'onde a une phase minimale à une frontière entre la première lentille et la deuxième lentille, une frontière entre la première lentille et la troisième lentille, une frontière entre la quatrième lentille et la deuxième lentille, et une frontière entre la quatrième lentille et la troisième lentille, et a une phase minimale aux sommets dans chacune de la première lentille, la deuxième lentille, la troisième lentille et la quatrième lentille, et éventuellement dans lequel, sur la base d'une phase la plus élevée de la lumière de la première bande de longueur d'onde étant fixée à 2π, la phase minimale à la frontière entre la première lentille et la deuxième lentille, la frontière entre la première lentille et la troisième lentille, la frontière entre la quatrième lentille et la deuxième lentille et la frontière entre la quatrième lentille et la troisième lentille est de 1,5π à 1,7π, et la phase minimale aux sommets de chacune de la première lentille, la deuxième lentille, la troisième lentille, et la quatrième lentille est de π à 1,3π*.*

10. Capteur d'images selon la revendication 6, dans lequel un profil de phase de la lumière de la deuxième bande de longueur d'onde immédiatement après avoir traversé le réseau de lentilles nanophotoniques diminue progressivement à partir d'un centre de la deuxième lentille sous la forme d'un cercle concentrique, et éventuellement dans lequel une phase de la lumière de la deuxième bande de longueur d'onde présente une phase minimale au centre de chacune de la première lentille, la troisième lentille et la quatrième lentille, et en outre éventuellement dans lequel, sur la base d'une phase la plus élevée de la lumière de la deuxième bande de longueur d'onde étant fixée à 2π, la phase minimale au centre de chacune de la première lentille et de la quatrième lentille est de 1,4π à 1,6π, et la phase minimale au centre de la troisième lentille est de 0,9π à 1,3π*.*

11. Capteur d'images selon la revendication 6, dans lequel un profil de phase de la lumière de la troisième bande de longueur d'onde immédiatement après avoir traversé le réseau de lentilles nanophotoniques diminue progressivement à partir d'un centre de la troisième lentille sous la forme d'un cercle concentrique, et éventuellement dans lequel le profil de phase de la lumière de la troisième bande de longueur d'onde présente une phase minimale à un centre de chacune de la première lentille, la deuxième lentille et la quatrième lentille, et en outre éventuellement dans lequel, sur la base d'une phase la plus élevée de la lumière de la troisième bande de longueur d'onde étant fixée à 2π, la phase minimale au centre de la première lentille et au centre de la quatrième lentille est de 1,4π à 1,6π, et la phase minimale au centre de la deuxième lentille est de 0,9π à 1,3π*.*

12. Capteur d'image selon l'une quelconque des revendications 6 à 11, dans lequel chacune de la pluralité de nanostructures a une forme de pilier et est inférieure à une plage de longueurs d'onde de lumière visible,
dans lequel les nanostructures sont respectivement disposées à un centre de chacune de la première lentille, la deuxième lentille, la troisième lentille et la quatrième lentille incluses dans le réseau de lentilles nanophotoniques,
dans lequel un diamètre d'une nanostructure disposée au centre de la première lentille est égal à un diamètre d'une nanostructure disposée au centre de la quatrième lentille, et
dans lequel le diamètre de la nanostructure disposée au centre de la première lentille, un diamètre d'une nanostructure disposée au centre de la deuxième lentille et un diamètre d'une nanostructure disposée au centre de la troisième lentille sont différents les uns des autres.

13. Capteur d'image selon l'une quelconque revendication précédente, comprenant en outre :
une couche de planarisation entre la couche de filtre de couleur et le réseau de lentilles nanophotoniques.

14. Appareil électronique (ED01), comprenant :
un ensemble de lentilles configuré pour former une image optique d'un sujet ;
un capteur d'image (1000) selon l'une quelconque des revendications précédentes configuré pour convertir l'image optique formée par l'ensemble de lentilles en un signal électrique ; et
un processeur (ED20) configuré pour traiter un signal généré par le capteur d'image.
